# EUROPEAN PATENT APPLICATION

(11) **EP 4 611 517 A1**
(43) Date of publication of application: **03.09.2025**
(21) Application number: 25159942.9
(22) Date of filing: 25.02.2025
(51) Int. Cl.: H10K 59/131, G09G 3/3208

(54) **DISPLAY APPARATUS**

(30) Priority: 29.02.2024 KR 20240030316
(71) Applicant: LG Display Co., Ltd., Seoul 07336 (KR)
(72) Inventor: KIM, HongSik, Paju-si, Gyeonggi-do 10845 (KR); CHO, Namwook, Paju-si, Gyeonggi-do 10845 (KR); KIM, EuiTae, Paju-si, Gyeonggi-do 10845 (KR)
(74) Representative: Viering, Jentschura & Partner mbB Patent- und Rechtsanwälte

(57) **Abstract**

A display apparatus (100, 200, 300, 400, 500, 600, 700) according to an exemplary embodiment of the present disclosure includes a substrate (110, 410) which includes an active area (AA) having a heterogeneous side (HTRS) and a non-active area (NA) which encloses the active area (AA), including a notch area (NTA) defined by a shape of the heterogeneous side (HTRS) of the active area (AA), a gate driver including a plurality of gate blocks (GB) disposed to be distributed in the active area (AA) and outputting a gate signal, a plurality of gate lines (GL) connected to the plurality of gate blocks (GB) to transmit the gate signal and a first compensation pattern (130, 230, 330, 430) disposed in at least one of the plurality of gate blocks (GB) and overlapping the plurality of gate lines (GL).

## Description

### CROSS-REFERENCE TO RELATED APPLICATIONS

This application claims the priority of Korean Patent Application No. 10-2024-0030316 filed on February 29, 2024, in the Korean Intellectual Property Office.

### BACKGROUND

### Technical Field

The present disclosure relates to a display apparatus, and more particularly, to a display apparatus in which a bezel is reduced or minimized.

### Description of the Related Art

As technology in modern society develops, display apparatuses are used in various ways to provide information to users. The display apparatuses are included in not only electronic signs which simply transmit visual information in one direction, but also various electronic devices which require higher level of technology to check user's input and provide information in response to the checked input.

For example, a display apparatus is included in a vehicle to provide various information to a driver and passengers of the vehicle. However, the display apparatus of the vehicle needs to appropriately display contents without interrupting the operation of the vehicle. For example, the display apparatus needs to limit the display of the contents which may reduce the concentration on the driving while the vehicle is in operation.

### BRIEF SUMMARY

Various embodiments of the present disclosure provide a display apparatus with a heterogeneous structure which compensates for an output of a signal according to a position.

Various embodiments of the present disclosure provide a display apparatus which reduces a bezel.

Technical benefits of the present disclosure are not limited to the above-mentioned benefits, and other benefits, which are not mentioned above, can be clearly understood by those skilled in the art from the following descriptions. Various embodiments of the present disclosure provide a display apparatus according to claim 1. Further embodiments are described in the dependent claims.

A display apparatus according to an exemplary embodiment of the present disclosure includes a substrate which includes an active area having a heterogeneous side, a non-active area which is adjacent to (e.g., encloses) the active area, and a notch area defined by a shape of the heterogeneous side of the active area, a gate driver including a plurality of gate blocks disposed to be distributed in the active area and configured to output a gate signal, a plurality of gate lines connected to the plurality of gate blocks to transmit the gate signal, and a first compensation pattern disposed in at least one of the plurality of gate blocks and overlapping the plurality of gate lines.

Other detailed matters of the exemplary embodiments are included in the detailed description and the drawings.

According to the present disclosure, an output of a gate signal and an output of a clock signal which are different according to the position due to the heterogeneous structure may be compensated.

According to the present disclosure, a gate driver which outputs a gate signal is disposed in an active area and a compensation pattern which compensates for the gate signal and the clock signal is disposed in the active area to reduce or minimize the bezel area.

The effects according to the present disclosure are not limited to the contents exemplified above, and more various effects are included in the present specification.

### BRIEF DESCRIPTION OF THE SEVERAL VIEWS OF THE DRAWINGS

The above and other aspects, features and other advantages of the present disclosure will be more clearly understood from the following detailed description taken in conjunction with the accompanying drawings, in which:
FIG. 1 is an exemplary plan view of a display apparatus according to an exemplary embodiment of the present disclosure;
FIG. 2 is an exemplary plan view of a display apparatus according to an exemplary embodiment of the present disclosure;
FIG. 3 is an exemplary circuit diagram of a pixel circuit of a display apparatus according to an exemplary embodiment of the present disclosure;
FIG. 4 is a cross-sectional view of a display apparatus according to an exemplary embodiment of the present disclosure;
FIG. 5 is an enlarged plan view of one pixel of a display apparatus according to an exemplary embodiment of the present disclosure;
FIG. 6 is a schematic view for explaining a first area of FIG. 1;
FIG. 7 is an enlarged plan view of one of gate drivers of FIG. 6;
FIG. 8 is a schematic view for explaining a second area of FIG. 1;
FIG. 9 is an enlarged plan view of one of gate blocks of FIG. 8;
FIG. 10 is a cross-sectional view taken along the line VIII-VIII' of FIG. 9;
FIG. 11 is an enlarged plan view of one of gate blocks of a display apparatus according to another exemplary embodiment of the present disclosure;
FIG. 12 is an enlarged plan view of one of gate blocks of a display apparatus according to still another exemplary embodiment of the present disclosure;
FIG. 13 is a cross-sectional view of a display apparatus according to still another exemplary embodiment of the present disclosure;
FIG. 14 is a cross-sectional view of one of gate blocks of a display apparatus according to still another exemplary embodiment of the present disclosure;
FIG. 15 is an exemplary plan view of a display apparatus according to still another exemplary embodiment of the present disclosure;
FIG. 16 is a plan view of one of gate blocks of a fourth area of FIG. 15;
FIG. 17 is a cross-sectional view taken along the line XV-XV' of FIG. 16;
FIG. 18 is a cross-sectional view of one of gate blocks of a display apparatus according to still another exemplary embodiment of the present disclosure; and
FIG. 19 is a cross-sectional view of one of gate blocks of a display apparatus according to still another exemplary embodiment of the present disclosure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, dimensions (e.g., length, width, height, thickness, radius, diameter, area, etc.), ratios, angles, numbers, and the like illustrated in the accompanying drawings for describing the exemplary embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only." Any references to singular may include plural unless expressly stated otherwise.

When the position relation between two parts is described using the terms such as "on," "above," "below," and "next," one or more parts may be positioned between the two parts unless the terms are used with the term "immediately" or "directly."

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

Although the terms "first," "second," and the like are used for describing various components, these components are not confined by these terms. These terms are merely used for distinguishing one component from the other components. Therefore, a first component to be mentioned below may be a second component in a technical concept of the present disclosure.

The features of various embodiments of the present disclosure can be partially or entirely adhered to or combined with each other and can be interlocked and operated in technically various ways, and the embodiments can be carried out independently of or in association with each other.

Hereinafter, exemplary embodiments of the present disclosure will be described in detail with reference to accompanying drawings.

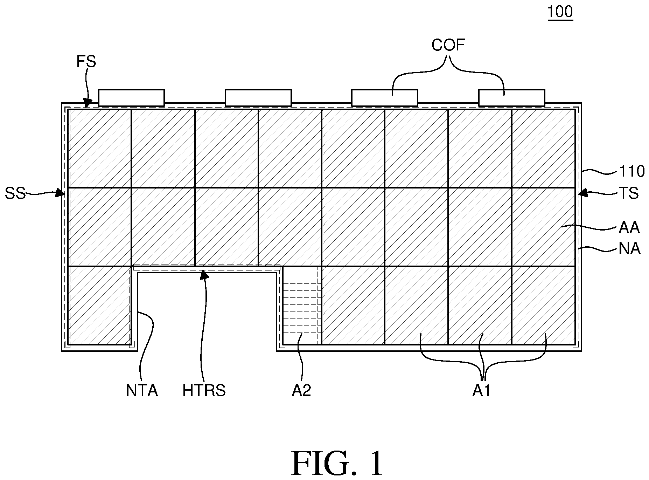

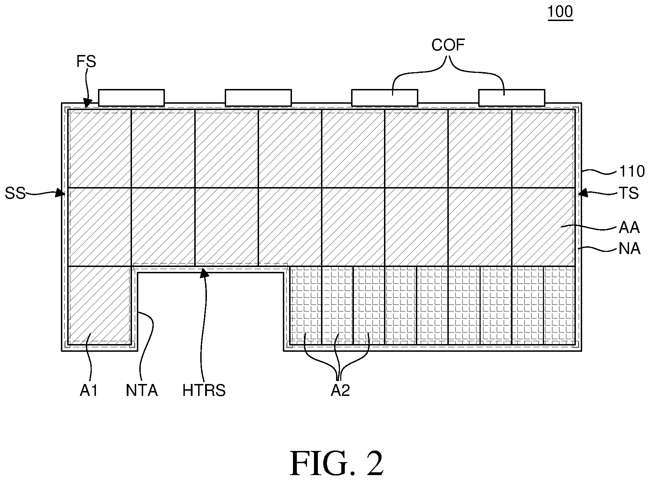

FIG. 1 is an exemplary plan view of a display apparatus according to an exemplary embodiment of the present disclosure. FIG. 2 is an exemplary plan view of a display apparatus according to an exemplary embodiment of the present disclosure. For the convenience of description, in FIGS. 1 and 2, among various components of the display apparatus 100, only a substrate 110 and a plurality of flexible films 120 are illustrated.

The substrate 110 is a base member which supports various components of the display apparatus 100 and may be configured by an insulating material. For example, the substrate 110 may be formed of a plastic material, such as polyimide (PI) or glass, but is not limited thereto.

The substrate 110 includes an active area AA and a non-active area NA.

The active area AA is an area where images are displayed. In the active area AA, a pixel which is formed by a plurality of sub pixels may be disposed to display images. For example, the pixel is configured by a plurality of sub pixels including a light emitting diode and a driving circuit to display images.

In the active area AA, one of four sides which form the active area AA may be a heterogeneous side having a heterogeneous structure. That is, according to FIG. 1, the active area AA has a first side FS, a second side SS, a third side SS, and a fourth side HTRS (also referred to as a heterogeneous side HTRS). The second side SS faces and is opposite to the third side SS, and the first side FS is between the second side SS and the third side SS. The heterogeneous side HTRS faces and is opposite to the first side FS. Unlike the first side FS, the heterogeneous side HTRS has a 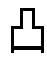 -shape. However, the heterogeneous side HTRS may take on various shapes (e.g., a curved shape, a triangular shape, a circular shape, a non-linear shape, a polygonal shape, or the like), excluding the traditional straight edge design (e.g. straight side shape). For example, referring to FIG. 1, a side located at a lower side, among four sides of the active area AA may be a heterogeneous side HTRS. That is, the heterogeneous side HTRS located at a lower side of the active area AA is inwardly recessed toward an upward direction of the active area AA so that a heterogeneous structure having a concave shape corresponding to the heterogeneous side may be defined. Even though in FIG. 1, it is illustrated that the heterogeneous structure is a rectangular concave structure, it is not limited thereto. Therefore, the heterogeneous structure is a structure caused by a heterogeneous side and is formed by a modified polygon, such as a circle, a triangle, a rectangle, a rhombus, a pentagon, and a hexagon so that it is difficult to be defined as a polygon. In a position in which the heterogeneous side is recessed, a pixel is not disposed so that the image is not displayed and it may be defined as a notch area NTA.

The active area AA may include a plurality of first areas A1 which is divided in a grid shape and at least one second area A2. Each of the plurality of first areas A1 and at least one second area A2 may be areas in which the gate drivers are distributed to be disposed. All the plurality of first areas A1 has areas with a predetermined size and at least one second area A2 is disposed so as to correspond to the notch area NTA and may be a smaller area than the plurality of first areas A1. At this time, for the convenience of design, the second area A2 may be disposed in a position adjacent to the notch area NTA. In the meantime, even though in FIG. 1, it is illustrated that the active area AA includes one second area A2, it is not limited thereto and two or more second areas may be disposed according to a shape, a position, and a size of the notch area. In the meantime, referring to FIG. 2, a plurality of first areas A1 and a plurality of second areas A2 may be disposed in the active area AA. For example, in a row area corresponding to the notch area NTA, one first area A1 and a plurality of second areas A2 may be disposed, but it is not limited thereto.

The non-active area NA is an area where no image is displayed and various wiring lines for driving the sub pixels disposed in the active area AA are disposed. The non-active area may be referred to as a bezel area.

A plurality of flexible films COF is disposed at one end of the substrate 110. The plurality of flexible films COF may be electrically connected to one end of the substrate 110. The plurality of flexible films COF is films in which various components are disposed on a base film having malleability to supply a signal to the plurality of sub pixels of the active area AA. One ends of the plurality of flexible films COF are disposed in the non-active area NA of the substrate 110 to supply a data voltage, etc., to the plurality of sub pixels of the active area AA. In the meantime, even though it is illustrated that the plurality of flexible films COF is four in FIG. 1, the number of flexible films COF may vary depending on the design, but is not limited thereto.

In the meantime, a driving IC, such as a data driver IC, may be disposed on the plurality of flexible films COF. The driving IC is a component which processes data for displaying images and a driving signal for processing the data. The driving IC may be disposed in a chip on glass (COG), a chip on film (COF), or a tape carrier package (TCP) manner depending on a mounting method. In the present disclosure, for the convenience of description, it is described that the driving IC is mounted on the plurality of flexible films COF by a chip on film technique, but is not limited thereto.

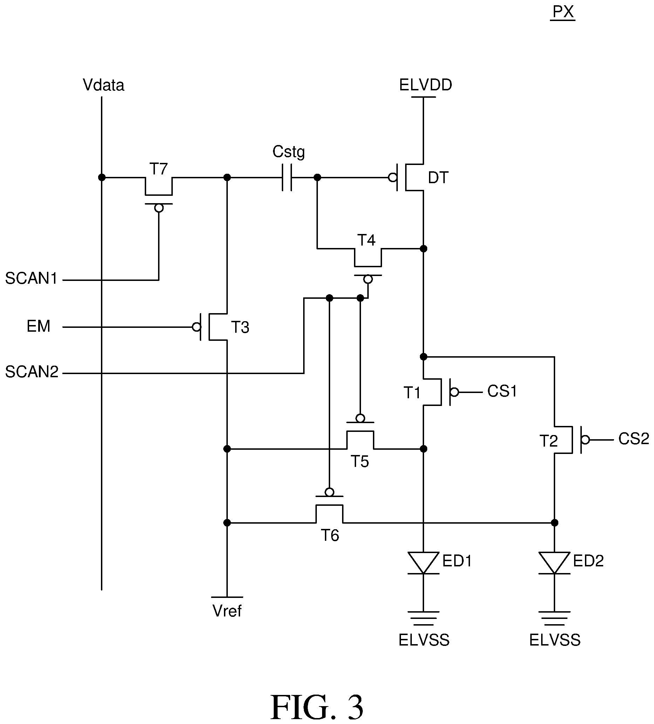

FIG. 3 is an exemplary circuit diagram of a pixel circuit of a display apparatus according to an exemplary embodiment of the present disclosure. The pixel PX may include a plurality of sub pixels which represents different colors and pixel circuits corresponding to the plurality of sub pixels, respectively. FIG. 3 illustrates an example of a pixel circuit for one sub pixel disposed in the pixel PX.

Referring to FIG. 3, the pixel circuit may include eight transistors and one capacitor.

The pixel circuit may include a driving transistor DT, a first transistor T1, a second transistor T2, a third transistor T3, a fourth transistor T4, a fifth transistor T5, a sixth transistor T6, a seventh transistor T7, and a capacitor Cstg.

Eight transistors included in the pixel circuit may be n-type transistors or p-type transistors. In the case of the p-type transistor, a low level voltage of each driving signal may refer to a voltage which turns on the TFT and a high level voltage of each driving signal may refer to a voltage which turns off the TFT.

Here, the low level voltage may correspond to a predetermined voltage which is lower than the high level. For example, the low level voltage may include a voltage corresponding to a range of -8 V to -12 V. The high level voltage may correspond to a predetermined voltage which is higher than the low level voltage. For example, the high level voltage may include a voltage corresponding to the range of 12 V to 16 V. According to the exemplary embodiment, the low level voltage may be referred to as a first voltage and the high level voltage may be referred to as a second voltage. In this case, the first voltage may be lower than the second voltage. However, the range of the low level voltage and the high level voltage is illustrative, but is not limited thereto.

Here, a first electrode or a second electrode of the transistor to be described below may refer to a source electrode or a drain electrode. However, the terms of the first electrode and the second electrode are terms for distinguishing the electrodes, but do not limit what corresponds to each electrode. Further, in each electrode, the first electrode may not refer to the same electrode. For example, a first electrode of the first transistor T1 may refer to a source electrode of the first transistor T1 and a first electrode of the sixth transistor T6 may refer to a drain electrode of the sixth transistor T6.

The driving transistor DT may be connected to the first transistor T1 connected to the first light emitting diode ED1 and the second transistor T2 connected to the second light emitting diode ED2. For example, the second electrode of the driving transistor DT may be connected to the first transistor T1 and the second transistor T2.

The driving transistor DT may be connected to a high potential power line which supplies a high potential power voltage ELVDD. For example, the first electrode of the driving transistor DT may be connected to the high potential power line. When the driving transistor DT is turned on, the high potential power voltage ELVDD supplied through the high potential power line may be transmitted from the first electrode to the second electrode of the driving transistor DT.

The first transistor T1 may be connected to at least one of the first light emitting diode ED1, the second transistor T2, the fourth transistor T4, and the fifth transistor T5.

For example, the first electrode of the first transistor T1 may be connected to the second transistor T2 and the fourth transistor T4. The second electrode of the first transistor T1 may be connected to the first light emitting diode ED1 and the fifth transistor T5. A gate electrode of the first transistor T1 may be connected to a wide field-of-view signal line to which a wide field-of-view signal CS1 is applied. The first transistor T1 may be turned on or turned off by the wide field-of-view signal CS1 supplied through the wide field-of-view signal line. When the first transistor T1 is turned on, the voltage through the driving transistor DT may be applied to the first light emitting diode ED1 (for example, an anode electrode of the first light emitting diode ED1).

Here, the wide field-of-view signal CS1 is supplied by a mode controller (or a mode control circuit) and may control the driving (or emission) of the first light emitting diode ED1 in which a first lens is disposed.

The second transistor T2 may be connected to at least one of the second light emitting diode ED2, the first transistor T1, the fourth transistor T4, and the sixth transistor T6.

For example, the first electrode of the second transistor T2 may be connected to the first transistor T1 and the fourth transistor T4. The second electrode of the second transistor T2 may be connected to the sixth transistor T6 and the second light emitting diode ED2. A gate electrode of the second transistor T2 may be connected to a narrow field-of-view signal line to which a narrow field-of-view signal CS2 is applied. The second transistor T2 may be turned on or turned off by the narrow field-of-view signal CS2 supplied through the narrow field-of-view signal line. Therefore, when the second transistor T2 is turned on, the voltage through the driving transistor DT may be applied to the second light emitting diode ED2 (for example, an anode electrode of the second light emitting diode ED2).

Here, the narrow field-of-view signal CS2 is supplied by the mode controller (or the mode control circuit) and may control the driving (or emission) of the second light emitting diode ED2 in which a second lens is disposed.

In the exemplary embodiment, the first lens may be disposed on the first light emitting diode ED1. A viewing angle of the area in which the first light emitting diode ED1 is disposed may correspond to a first value by the first lens. For example, the viewing angle of the area in which the first light emitting diode ED1 is disposed may be equal to or larger than the first value. The second lens may be disposed on the second light emitting diode ED2. A viewing angle of the area in which the second light emitting diode ED2 is disposed may correspond to a second value by the second lens. The second value may be smaller than the first value. For example, the viewing angle of the area in which the second light emitting diode ED2 is disposed may be equal to or smaller than the second value.

In the exemplary embodiment, the area in which the first light emitting diode ED1 of the pixel PX is disposed may have a viewing angle of a first value to supply light to a range corresponding to the front passenger seat and the driver seat next to the front passenger seat. The area in which the second light emitting diode ED2 is disposed may have a viewing angle of a second value to supply light to a range corresponding to the front passenger seat.

For example, contents (or images) provided through the first light emitting diode ED1 of the pixel PX may be shared by surrounding people who are adjacent to the user in the first direction. When the contents are provided through the first light emitting diode ED1, the contents are provided at a first viewing angle range which is wider than a second viewing angle range supplied by the second light emitting diode ED2 and this may be referred to as a first mode. Further, the contents provided by the second light emitting diode ED2 may not be shared by people around the user. When the contents are provided through the second light emitting diode ED2, the contents are provided at a second viewing angle range which is narrower than the first viewing angle range supplied by the first light emitting diode ED1 and this may be referred to as a second mode.

The third transistor T3 may be connected to at least one of the fifth transistor T5, the sixth transistor T6, the seventh transistor T7, and the capacitor Cstg.

For example, the first electrode of the third transistor T3 may be connected to a reference voltage line which supplies a reference voltage Vref. Further, the first electrode of the third transistor T3 may be connected to the fifth transistor T5 and the sixth transistor T6. The second electrode of the third transistor T3 may be connected to the sixth transistor T6 and the capacitor Cstg. The gate electrode of the third transistor T3 may be connected to an emission signal line which supplies an emission signal EM. The third transistor T3 may be turned on or off by the emission signal EM. Therefore, when the third transistor T3 is turned on, the reference voltage Vref may be applied to the first electrode of the capacitor Cstg.

The fourth transistor T4 may be connected to at least one of the driving transistor DT, the first transistor T1, the second transistor T2, and the capacitor Cstg.

For example, the first electrode of the fourth transistor T4 may be connected to the driving transistor DT and the capacitor Cstg. The second electrode of the fourth transistor T4 may be connected to the driving transistor DT, the first transistor T1, and the second transistor T2. The gate electrode of the fourth transistor T4 may be connected to the second scan line which supplies the second scan signal SCAN2. The fourth transistor T4 may be supplied with the second scan signal SCAN2 and may be turned on or turned off by the second scan signal SCAN2. Therefore, when the fourth transistor T4 is turned on, the gate electrode and the second electrode of the driving transistor DT may be diode-connected to be connected as a diode.

The fifth transistor T5 may be connected to at least one of the first transistor T1, the third transistor T3, and the first light emitting diode ED1.

For example, the first electrode of the fifth transistor T5 may be connected to the third transistor T3 and a reference voltage line which supplies a reference voltage Vref. The second electrode of the fifth transistor T5 may be connected to the first transistor T1 and the first light emitting diode ED1. The gate electrode of the fifth transistor T5 may be connected to the second scan line. Therefore, the fifth transistor T5 may be supplied with the second scan signal SCAN2 and may be turned on or turned off by the second scan signal SCAN2. Therefore, when the fifth transistor T5 is turned on, the reference voltage Vref may be applied to the first light emitting diode ED1 (for example, an anode electrode of the first light emitting diode ED1).

The sixth transistor T6 may be connected to at least one of the second transistor T2, the third transistor T3, and the second light emitting diode ED2.

For example, the first electrode of the sixth transistor T6 may be connected to the third transistor T3 and a reference voltage line which supplies a reference voltage Vref. The second electrode of the sixth transistor T6 may be connected to the second transistor T2 and the second light emitting diode ED2. The gate electrode of the sixth transistor T6 may be connected to the second scan line. Therefore, the sixth transistor T6 may be supplied with the second scan signal SCAN2 and may be turned on or turned off by the second scan signal SCAN2. Therefore, when the sixth transistor T6 is turned on, the reference voltage Vref may be applied to the second light emitting diode ED2 (for example, an anode electrode of the second light emitting diode ED2).

The seventh transistor T7 may be connected to at least one of the third transistor T3 and the capacitor Cstg.

For example, the first electrode of the seventh transistor T7 may be connected to a data line which supplies a data voltage Vdata. The second electrode of the seventh transistor T7 may be connected to the third transistor T3 and the capacitor Cstg. The gate electrode of the seventh transistor T7 may be connected to the first scan line which supplies the first scan signal SCAN1. The seventh transistor T7 may be supplied with the first scan signal SCAN1 and may be turned on or turned off by the first scan signal SCAN1. Therefore, when the seventh transistor T7 is turned on, the data voltage Vdata may be applied to the first electrode of the capacitor Cstg.

The first light emitting diode ED1 and the second light emitting diode ED2 may be connected to the low potential power line which supplies a low potential power voltage ELVSS. For example, a cathode electrode of the first light emitting diode ED1 and a cathode electrode of the second light emitting diode ED2 are connected to the low potential power line to be supplied with the low potential power voltage ELVSS. The low potential power voltage may be a ground voltage (for example, 0 V). For example, the cathode electrode of the first light emitting diode ED1 and the cathode electrode of the second light emitting diode ED2 may be supplied with a voltage corresponding to the ground voltage, but are not limited thereto.

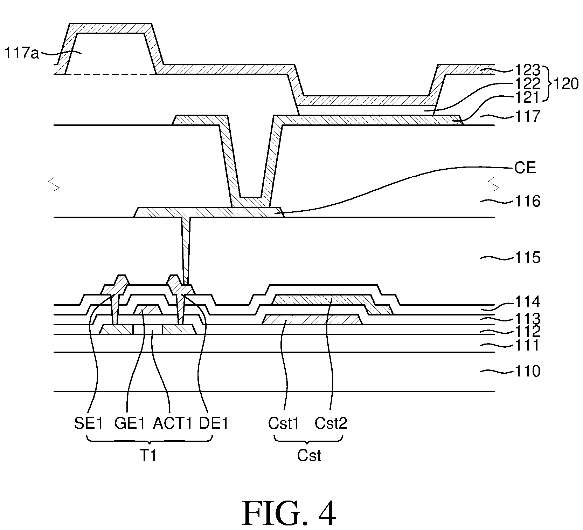

FIG. 4 is a cross-sectional view of a display apparatus according to an exemplary embodiment of the present disclosure. In FIG. 4, for the convenience of description, among various components of the display apparatus 100 according to the exemplary embodiment of the present disclosure, only a substrate 110, a first transistor T1, a storage capacitor Cst, a buffer layer 111, a gate insulating layer 112, a first interlayer insulating layer 113, a second interlayer insulating layer 114, a first planarization layer 115, a second planarization layer 116, a connection electrode CE, a light emitting diode 120, a bank layer 117, and a spacer 117a are illustrated.

Referring to FIG. 4, the display apparatus 100 according to the exemplary embodiment of the present disclosure includes a substrate 110, a first transistor T1, a storage capacitor Cst, a gate insulating layer 112, a first interlayer insulating layer 113, a second interlayer insulating layer 114, a first planarization layer 115, a second planarization layer 116, a light emitting diode 120, and a bank layer 117.

The substrate 110 is a base member which supports various components of the display apparatus 100 and may be configured by an insulating material. For example, the substrate may be formed of glass or a plastic material, but is not limited thereto.

A buffer layer 111 may be disposed on the substrate 110. The buffer layer 111 may be formed on an entire surface of the substrate 110. The buffer layer 111 may be formed as a single layer of silicon nitride (SiNx) or silicon oxide (SiOx) or multiple layers thereof. The buffer layer 111 may enhance an adhesiveness between layers formed on the buffer layer 111 and the substrate 110. The buffer layer 111 is not an essential component and may be omitted based on a type or a material of the substrate 110 and a structure and a type of a transistor.

The first transistor T1 may be disposed on the buffer layer 111. The first transistor T1 may include a first active layer ACT1, a first gate electrode GE1, a first source electrode SE1, and a first drain electrode DE1. A first active layer ACT1 of the first transistor T1 may be disposed on the buffer layer 111.

The first active layer ACT1 may be formed of a semiconductor material such as an oxide semiconductor, amorphous silicon, or polysilicon, but is not limited thereto.

The gate insulating layer 112 may be disposed on the first active layer ACT1 of the first transistor T1. The gate insulating layer 112 may be formed as a single layer of silicon nitride (SiNx) or silicon oxide (SiOx) or a multi-layer thereof. In the gate insulating layer 112, a contact hole through which each of the first source electrode SE1 and the first drain electrode DE1 of the first transistor T1 is connected to the first active layer ACT1 of the first transistor T1 may be formed.

The first gate electrode GE1 of the first transistor T1 may be disposed on the gate insulating layer 112. The first gate electrode GE1 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof. The first gate electrode GE1 may be formed on the gate insulating layer 112 so as to overlap the first active layer ACT1 of the first transistor T1.

The first interlayer insulating layer 113 may be disposed on the gate insulating layer 112 and the first gate electrode GE1. The first interlayer insulating layer 113 may be configured by a single layer of silicon nitride (SiNx) or silicon oxide (SiOx) or a multi-layer thereof. A contact hole may be formed in the first interlayer insulating layer 113 to expose the first active layer ACT1 of the first transistor T1.

The second interlayer insulating layer 114 may be disposed on the first interlayer insulating layer 113. A contact hole may be formed in the second interlayer insulating layer 114 to expose the first active layer ACT1 of the first transistor T1. The second interlayer insulating layer 114 may be configured by a single layer of silicon nitride (SiNx) or silicon oxide (SiOx) or a multi-layer thereof.

The first source electrode SE1 and the first drain electrode DE1 of the first transistor T1 may be disposed on the second interlayer insulating layer 114.

The first source electrode SE1 and the first drain electrode DE1 of the first transistor T1 may be connected to the first active layer ACT1 of the first transistor T1 through contact holes formed in the gate insulating layer 112, the first interlayer insulating layer 113, and the second interlayer insulating layer 114. Therefore, the first source electrode SE1 of the first transistor T1 may be connected to a first source region of the first active layer ACT1 through the contact holes formed in the gate insulating layer 112, the first interlayer insulating layer 113, and the second interlayer insulating layer 114. The first drain electrode DE1 of the first transistor T1 may be connected to a first drain region of the first active layer ACT1 through the contact holes formed in the gate insulating layer 112, the first interlayer insulating layer 113, and the second interlayer insulating layer 114.

The storage capacitor Cst may include a first capacitor electrode Cst1 and a second capacitor electrode Cst2.

The first capacitor electrode Cst1 may be disposed on the gate insulating layer 112. The first capacitor electrode Cst1 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof. The first capacitor electrode Cst1 may be formed of the same material as the first gate electrode GE1, but is not limited thereto.

The second capacitor electrode Cst2 may be disposed on the first interlayer insulating layer 113. The second capacitor electrode Cst2 may be disposed on the first interlayer insulating layer 113 so as to overlap the first capacitor electrode Cst1. For example, the second capacitor electrode Cst2 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

A passivation layer may be disposed on the first source electrode SE1 and the first drain electrode DE1 of the first transistor T1 and the second interlayer insulating layer 114. The passivation layer is an insulating layer which protects elements therebelow and may be configured by a single layer of silicon nitride (SiNx) or silicon oxide (SiOx) or a multi-layer thereof.

The first planarization layer 115 may be disposed on the second interlayer insulating layer 114. The first planarization layer 115 is provided to relieve a step of a lower structure. The first planarization layer may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

The connection electrode CE may be disposed on the first planarization layer 115. The connection electrode CE may be electrically connected to the first drain electrode DE1 of the first transistor T1 through a contact hole formed in the first planarization layer 115. The connection electrode CE may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The second planarization layer 116 may be disposed on the connection electrode CE and the first planarization layer 115. The second planarization layer 116 is provided to relieve a step of a lower structure. The second planarization layer may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

The light emitting diode 120 may be disposed on the second planarization layer 116. The light emitting diode 120 may include a first electrode 121, an emission structure 122, and a second electrode 123.

The first electrode 121 may be disposed on the second planarization layer 116. The first electrode 121 is an anode electrode and may be electrically connected to the first drain electrode DE1 of the first transistor T1 through a contact hole.

Since the display apparatus 100 according to the exemplary embodiment of the present disclosure is a top emission display apparatus, the first electrode 121 may be formed with a double-layered structure including a transparent conductive layer and a reflective layer having a high reflection efficiency. The transparent conductive layer may be formed of a material having a relatively high work function such as indium tin oxide (ITO) or indium zinc oxide (IZO). The reflective layer may be formed to have a single layer or a multi-layered structure including aluminum (Al), silver (Ag), copper (Cu), lead (Pb), molybdenum (Mo), and titanium (Ti), or an alloy thereof. For example, the first electrode 121 may be formed with a structure in which a transparent conductive layer, a reflective layer, and a transparent conductive layer are sequentially laminated. However, the first electrode 121 is not limited thereto, but may also be formed to have a structure in which the transparent conductive layer and the reflective layer are sequentially laminated.

The bank layer 117 may be disposed on the first electrode 121 and the second planarization layer 116.

An opening may be formed in the bank layer 117 to expose the first electrode 121. Since the bank layer 117 defines an emission area of the display apparatus 100, the bank layer 117 may also be referred to as a pixel definition layer. The bank layer 117 may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

A spacer 117a may be further disposed on the bank layer 117.

The spacer 117a may serve to support a mask when the mask is aligned on the bank layer 117 in a process for depositing the first electrode 121. The spacer 117a may be integrally configured with the bank layer 117. The spacer 117a may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

The emission structure 122 may be disposed on the first electrode 121. The emission structure 122 may include a material which emits light of a specific color. For example, the emission structure 122 may include an emission material which emits any one of red light, green light, and blue light. Specifically, the emission structure 122 may include at least one of a hole injection layer (HIL), a hole transport layer (HTL), an emission layer (EML), an electron transport layer (ETL), and an electron injection layer (EIL). Some components of the emission structure 122 may be omitted depending on the structure or the characteristic of the display apparatus 100.

The second electrode 123 may be further disposed on the emission structure 122, the bank layer 117, and the spacer 117a. The second electrode 123 is a cathode electrode and may be disposed on the emission structure 122 so as to be opposite to the first electrode 121 with the emission structure 122 therebetween. The second electrode 123 supplies electrons to the emission structure 122. For example, the second electrode 123 may be formed of a conductive material having a low work function. When the display apparatus 100 is a top emission type display apparatus, the second electrode 123 may be formed of transparent conductive oxide, such as indium tin oxide or indium zinc oxide or a transparent conductive material such as ytterbium (Yb), but is not limited thereto.

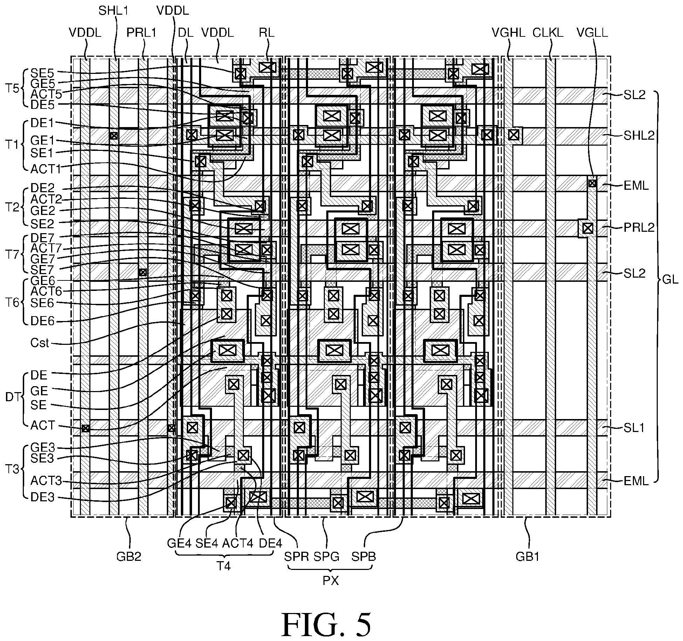

FIG. 5 is an enlarged plan view of one pixel of a display apparatus according to an exemplary embodiment of the present disclosure. FIG. 5 is an enlarged plan view of a red sub pixel SPR, a green sub pixel SPG, and a blue sub pixel SPB which configure one pixel PX. In FIG. 5, for the convenience of description, only a first transistor T1, a second transistor T2, a third transistor T3, a fourth transistor T4, a fifth transistor T5, a sixth transistor T6, a seventh transistor T7, a driving transistor DT, a storage capacitor Cst, a data line DL, a high potential power line VDDL, a reference voltage line RL, a first scan signal line SL1, a second scan signal line SL2, an emission signal line EML, a first wide field-of-view signal line SHL1, a second wide field-of-view signal line SHL2, a first narrow field-of-view signal line PRL1, a second narrow field-of-view signal line PRL2, a clock line CLKL, a gate high voltage line VGHL, and a gate low voltage line VGLL are illustrated.

Referring to FIG. 5, the display apparatus 100 may include a plurality of red sub pixels SPR, a plurality of green sub pixels SPG, a plurality of blue sub pixels SPB, and a plurality of gate blocks GB.

The plurality of gate blocks GB may include a plurality of first gate blocks GB1 and a plurality of second gate blocks GB2. The plurality of gate blocks GB1 and GB2 may be disposed one side of one of the red sub pixel SPR, the green sub pixel SPG, and the blue sub pixel SPB. For example, when the red sub pixel SPR, the green sub pixel SPG, and the blue sub pixel SPB are sequentially disposed along the row direction, the first gate block GB1 may be disposed at a right side of the blue sub pixel SPB and the second gate block GB2 may be disposed at a left side of the red sub pixel SPR. However, the placement order of the red sub pixel SPR, the green sub pixel SPG, the blue sub pixel SPB, and the gate blocks GB1 and GB2 is not limited thereto. In the first gate block GB1, a configuration of the gate driver may be disposed to be separated. For example, in the first gate block GB1, a clock line CLKL which supplies a clock signal to the gate driver, a gate high voltage line VGHL which supplies a gate high voltage, and a gate low voltage line VGLL which supplies a gate low voltage may be disposed. In the second gate block GB2, a first narrow field-of-view signal line PRL1 which extends along the column direction and supplies a narrow field-of-view mode signal, a first wide field-of-view signal line SHL1 which supplies a wide field-of-view mode signal, a high potential power line VDDL which supplies a high potential power, and a low potential power line VSSL which supplies a low potential power may be disposed.

Referring to FIG. 5, a data line DL, a high potential power line VDDL, and a reference voltage line RL extending in a column direction may be disposed on the substrate 110. For example, the data line DL, the high potential power line VDDL, and the reference voltage line RL may be disposed in this order from the left side. The data line DL, the high potential power line VDDL, and the reference voltage line RL are disposed on the same layer of the substrate 110 to be formed of the same material. For example, the data line DL, the high potential power line VDDL, and the reference voltage line RL may be configured by a conductive material such as copper (Cu), aluminum (Al), molybdenum (Mo), nickel (Ni), titanium (Ti), chrome (Cr), or an alloy thereof, but are not limited thereto.

The data line DL extends in the column direction on the substrate 110 to transmit a data voltage supplied from the data driver to each sub pixel SPR, SPG, SPB.

The high potential power line VDDL extends in the column direction on the substrate 110 to transmit a high potential voltage for driving the light emitting diode to each sub pixel SPR, SPG, SPB.

The reference voltage line RL extends in the column direction on the substrate 110 to transmit a reference voltage to each sub pixel SPR, SPG, SPB.

Referring to FIG. 5, a plurality of gate lines GL extending in the row direction may be disposed on the substrate 110. The plurality of gate lines GL may include a first scan signal line SL1, a second scan signal line SL2, an emission signal line EML, a second wide field-of-view signal line SHL2, and a second narrow field-of-view signal line PRL2. The first scan signal line SL1, the second scan signal line SL2, the emission signal line EML, the second wide field-of-view signal line SHL2, and the second narrow field-of-view signal line PRL2 are spaced apart from each other to be disposed in parallel. The first scan signal line SL1, the second scan signal line SL2, the emission signal line EML, the second wide field-of-view signal line SHL2, and the second narrow field-of-view signal line PRL2 are disposed on the same layer on the substrate 110 to be formed of the same material. For example, the first scan signal line SL1, the second scan signal line SL2, the emission signal line EML, the second wide field-of-view signal line SHL2, and the second narrow field-of-view signal line PRL2 may be formed of a conductive material, such as copper (Cu), aluminum (Al), molybdenum (Mo), nickel (Ni), titanium (Ti), chrome (Cr), or an alloy thereof, but are not limited thereto.

The first scan signal line SL1 extends in a row direction on the substrate 110 to intersect the data line DL, the high potential power line VDDL, and the reference voltage line RL extending in the column direction. The first scan signal line SL1 may transmit a first scan signal supplied from the gate driver to each sub pixel SPR, SPG, SPB.

The second scan signal line SL2 extends in a row direction on the substrate 110 to intersect the data line DL, the high potential power line VDDL, and the reference voltage line RL extending in the column direction. The second scan signal line SL2 may transmit a second scan signal supplied from the gate driver to each sub pixel SPR, SPG, SPB. Even though in FIG. 3, it is illustrated that two second scan signal lines SL2 are configured to transmit the second scan signal, it is not limited thereto and one second scan signal line SL2 may be disposed depending on the design.

The emission signal line EML extends in a row direction on the substrate 110 to intersect the data line DL, the high potential power line VDDL, and the reference voltage line RL extending in the column direction. The emission signal line EML may transmit an emission signal supplied from the gate driver to each sub pixel SPR, SPG, SPB. Even though in FIG. 4, it is illustrated that two emission signal lines EML are configured to transmit the emission signal, it is not limited thereto and one emission signal line EML may be disposed depending on the design.

The second wide field-of-view signal line SHL2 extends in a row direction on the substrate 110 to be electrically connected to the first wide field-of-view signal line SHL1 extending in the column direction through a contact hole. The second wide field-of-view signal line SHL2 may transmit a wide field-of view mode signal to each sub pixel SPR, SPG, SPB.

The second narrow field-of-view signal line PRL2 extends in a row direction on the substrate 110 to be electrically connected to the first narrow field-of-view signal line PRL1 extending in the column direction through a contact hole. The second narrow field-of-view signal line PRL2 may transmit a narrow field-of view mode signal to each sub pixel SPR, SPG, SPB.

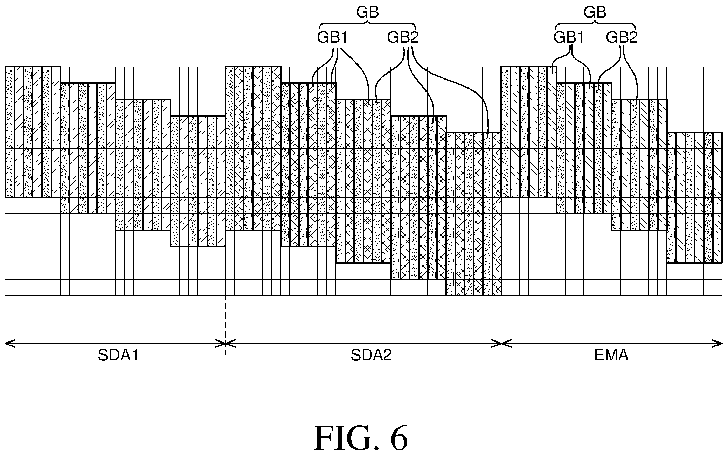

FIG. 6 is a schematic view for explaining a first area of FIG. 1. In FIG. 6, for the convenience of description, only a first scan driver area SDA1, a second scan driver area SDA2, an emission driver area EMA, and a plurality of gate blocks GB disposed in a first area A1 are illustrated.

A display apparatus 100 according to an exemplary embodiment of the present disclosure includes a gate driver.

The gate driver includes a first scan driver, a second scan driver, and an emission driver which output a scan signal and an emission signal in response to a gate timing control signal. The gate driver receives a clock signal and a gate control signal to generate and output a signal which turns on or turns off transistors disposed on the substrate 110. Specifically, the first scan driver, the second scan driver, and the emission driver may output a low level voltage or a high level voltage of scan signal or emission signal to transistors disposed in each sub pixel. For example, the first scan driver may output a first scan signal SCAN1 to the first scan signal line SL1 connected to the first scan driver in response to a gate control signal from the timing controller. The second scan driver may output a second scan signal SCAN2 to the second scan signal line SL2 connected to the second scan driver in response to the gate control signal from the timing controller. The emission driver may output an emission signal EM to the emission signal line EML connected to the emission driver in response to the gate control signal from the timing controller.

Referring to FIG. 6, in the active area AA, the first scan driver area SDA1, the second scan driver area SDA2, and the emission driver area EMA may be disposed.

The first scan driver area SDA1 is an area in which a first scan driver is disposed, the second scan driver area SDA2 is an area in which a second scan driver is disposed, and the emission driver area EMA is an area in which an emission driver is disposed. Each of the first scan driver area SDA1, the second scan driver area SDA2, and the emission driver area EMA includes a plurality of first gate blocks GB1 and a plurality of second gate blocks GB2, respectively.

The plurality of first gate blocks GB1 and the plurality of second gate blocks GB2 may be disposed in the column direction in the active area AA. For example, in each of the first scan driver area SDA1, the second scan driver area SDA2, and the emission driver area EMA, three first gate blocks GB1 and two second gate blocks GB2 may be disposed to extend in the column direction. In each of the first scan driver area SDA1, the second scan driver area SDA2, and the emission driver area EMA, the plurality of first gate blocks GB1 and the plurality of second gate blocks GB2 may be alternately disposed in the row direction. However, it is not limited thereto and the number and the placement position of the plurality of first gate blocks GB1 and the plurality of second gate blocks GB2 may vary depending on the design.

In the plurality of first gate blocks GB1, the first scan driver, the second scan driver, and the emission driver may be separately disposed. In the plurality of second gate blocks GB2, a plurality of power lines which transmits a constant voltage to the sub pixels SPR, SPG, and SPB, a plurality of first narrow field-of-view signal lines PRL1 which supplies a narrow field-of-view mode signal, and a plurality of first wide field-of-view signal lines SHL1 which supplies a wide field-of-view mode signal may be disposed. For example, the plurality of power lines may include a high potential power line VDDL and a low potential power line VSSL.

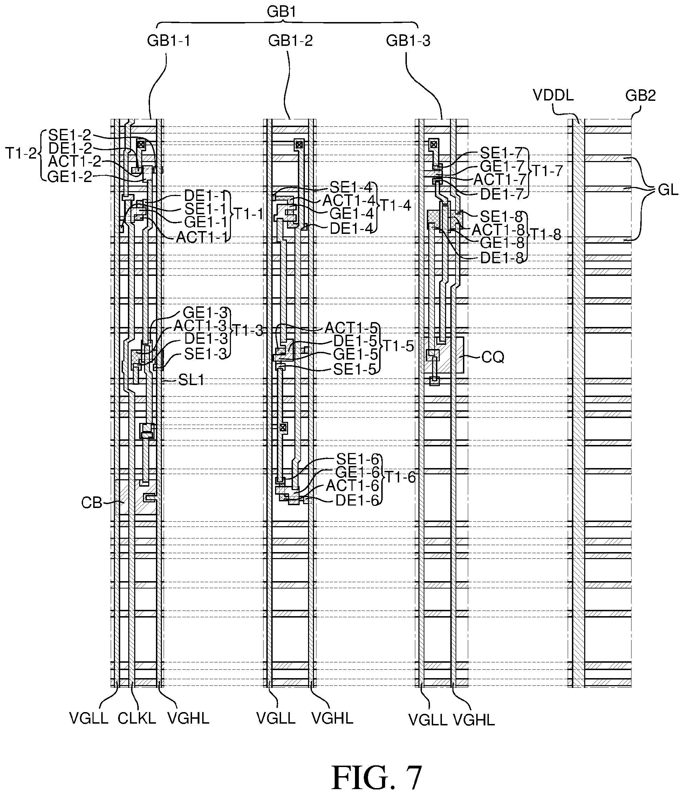

FIG. 7 is an enlarged plan view of one of gate drivers of FIG. 6. In FIG. 7, only some gate blocks GB1 and GB2 disposed in the first scan driver area SDA1 are illustrated.

Referring to FIG. 7, the plurality of first gate blocks GB1 may include a 1-1-th gate block GB1-1, a 1-2-th gate block GB1-2, and a 1-3-th gate block GB1-3. In the 1-1-th gate block GB1-1, the 1-2-th gate block GB1-2, and the 1-3-th gate block GB1-3, configurations of the first scan driver may be separately disposed.

The 1-1-th gate block GB1-1 may include a 1-1-th transistor T1-1, a 1-2-th transistor T1-2, a 1-3-th transistor T1-3, and a first capacitor CB.

The 1-1-th transistor T1-1 may include a 1-1-th source electrode SE1-1, a 1-1-th drain electrode DE1-1, a 1-1-th gate electrode GE1-1, and a 1-1-th active layer ACT1-1. The 1-1-th source electrode SE1-1 may be electrically connected to a gate low voltage line VGLL to which a gate low voltage is applied. The 1-1-th drain electrode DE1-1 may be electrically connected to a 1-2-th gate electrode GE1-2 of the 1-2-th transistor T1-2 and a 1-3-th gate electrode GE1-3 of the 1-3-th transistor T1-3. The 1-1-th gate electrode GE1-1 may be electrically connected to a clock line CLKL to which a clock signal is applied. The 1-1-th active layer ACT1-1 may overlap the 1-1-th gate electrode GE1-1 below the 1-1-th gate electrode GE1-1.

The 1-2-th transistor T1-2 may include a 1-2-th source electrode SE1-2, a 1-2-th drain electrode DE1-2, a 1-2-th gate electrode GE1-2, and a 1-2-th active layer ACT1-2. The 1-2-th source electrode SE1-2 may be electrically connected to a gate high voltage line VGHL to which a gate high voltage is applied. The 1-2-th drain electrode DE1-2 may be electrically connected to the 1-2-th gate block GB1-2. The 1-2-th gate electrode GE1-2 may be electrically connected to a drain electrode DE1-1 of the 1-1-th transistor T1-1 and a 1-3-th gate electrode G1-3 of the 1-3-th transistor T1-3. The 1-2-th active layer ACT1-2 may overlap the 1-2-th gate electrode GE1-2 below the 1-2-th gate electrode GE1-2.

The 1-3-th transistor T1-3 may include a 1-3-th source electrode SE1-3, a 1-3-th drain electrode DE1-3, a 1-3-th gate electrode GE1-3, and a 1-3-th active layer ACT1-3. The 1-3-th source electrode SE1-3 may be electrically connected to a gate high voltage line VGHL. The 1-3-th drain electrode DE1-3 may be electrically connected to the first scan signal line SL1 to which the first scan signal is transmitted. The 1-3-th gate electrode GE1-3 may be electrically connected to a drain electrode DE1-1 of the 1-1-th transistor T1-1 and a 1-2-th gate electrode G1-2 of the 1-2-th transistor T1-2. The 1-3-th active layer ACT1-3 may overlap the 1-3-th gate electrode GE1-3 below the 1-3-th gate electrode GE1-3.

The first capacitor CB may be electrically connected to the 1-3-th gate electrode GE1-3 of the 1-3-th transistor T1-3 and the gate high voltage line VGHL.

The 1-2-th gate block GB1-2 may include a 1-4-th transistor T1-4, a 1-5-th transistor T1-5, and a 1-6-th transistor T1-6.

The 1-4-th transistor T1-4 may include a 1-4-th source electrode SE1-4, a 1-4-th drain electrode DE1-4, a 1-4-th gate electrode GE1-4, and a 1-4-th active layer ACT1-4. The 1-4-th source electrode SE1-4 may be electrically connected to a gate low voltage line VGLL to which a gate low voltage is applied. The 1-4-th drain electrode DE1-4 may be electrically connected to the 1-2-th drain electrode DE1-2 of the 1-2-th transistor T1-2, a 1-7-th transistor T1-7 of a 1-3-th gate block GB1-3, and a 1-6-th gate electrode GE1-6 of the 1-6-th transistor T1-6. The 1-4-th gate electrode GE1-4 may be electrically connected to a 1-5-th gate electrode GE1-5 of the 1-5-th transistor T1-5. The 1-4-th active layer ACT1-4 may overlap the 1-4-th gate electrode GE1-4 below the 1-4-th gate electrode GE1-4.

The 1-5-th transistor T1-5 may include a 1-5-th source electrode SE1-5, a 1-5-th drain electrode DE1-5, a 1-5-th gate electrode GE1-5, and a 1-5-th active layer ACT1-5. The 1-5-th source electrode SE1-5 may be electrically connected to a 1-6-th source electrode SE1-6 of the 1-6-th transistor T1-6, the first capacitor CB, and the 1-3-th gate electrode GE1-3 of the 1-3-th transistor T1-3. The 1-5-th drain electrode DE1-5 may be electrically connected to a gate high voltage line VGHL to which a gate high voltage is applied. The 1-5-th gate electrode GE1-5 may be electrically connected to the 1-4-th gate electrode GE1-4 of the 1-4-th transistor T1-4. The 1-5-th active layer ACT1-5 may overlap the 1-5-th gate electrode GE1-5 below the 1-5-th gate electrode GE1-5.

The 1-6-th transistor T1-6 may include a 1-6-th source electrode SE1-6, a 1-6-th drain electrode DE1-6, a 1-6-th gate electrode GE1-6, and a 1-6-th active layer ACT1-6. The 1-6-th source electrode SE1-6 may be electrically connected to a 1-5-th source electrode SE1-5 of the 1-5-th transistor T1-5, the first capacitor CB, and the 1-3-th gate electrode GE1-3 of the 1-3-th transistor T1-3. The 1-6-th drain electrode DE1-6 may be electrically connected to a gate high voltage line VGHL to which a gate high voltage is applied. The 1-6-th gate electrode GE1-6 may be electrically connected to the 1-4-th drain electrode DE1-4 of the 1-4-th transistor T1-4. The 1-6-th active layer ACT1-6 may overlap the 1-6-th gate electrode GE1-6 below the 1-6-th gate electrode GE1-6.

The 1-3-th gate block GB1-3 may include a 1-7-th transistor T1-7, a 1-8-th transistor T1-8, and a second capacitor CQ.

The 1-7-th transistor T1-7 may include a 1-7-th source electrode SE1-7, a 1-7-th drain electrode DE1-7, a 1-7-th gate electrode GE1-7, and a 1-7-th active layer ACT1-7. The 1-7-th source electrode SE1-7 may be electrically connected to the 1-1-th drain electrode DE1-4 of the 1-4-th transistor T1-4 and the 1-2-th drain electrode DE1-2 of the 1-2-th transistor T1-2. The 1-7-th drain electrode DE1-7 may be electrically connected to a 1-8-th gate electrode GE1-8 of the 1-8-th transistor T1-8. The 1-7-th gate electrode GE1-7 may be electrically connected to a gate low voltage line VGLL to which a gate low voltage is applied. The 1-7-th active layer ACT1-7 may overlap the 1-7-th gate electrode GE1-7 below the 1-7-th gate electrode GE1-7.

The 1-8-th transistor T1-8 may include a 1-8-th source electrode SE1-8, a 1-8-th drain electrode DE1-8, a 1-8-th gate electrode GE1-8, and a 1-8-th active layer ACT1-8. The 1-8-th source electrode SE1-8 may be electrically connected to a gate high voltage line VGHL to which a gate high voltage is applied. The 1-8-th drain electrode DE1-8 may be electrically connected to the second capacitor CQ. The 1-8-th gate electrode GE1-8 may be electrically connected to a 1-7-th drain electrode DE1-7 of the 1-7-th transistor T1-7 and the second capacitor CQ. The 1-8-th active layer ACT1-8 may overlap the 1-8-th gate electrode GE1-8 below the 1-8-th gate electrode GE1-8.

The second capacitor CQ may be electrically connected to the 1-8-th gate electrode GE1-8 of the 1-8-th transistor T1-8, the 1-8-th drain electrode DE1-8 of the 1-8-th transistor T1-8, and a first scan signal line SL1 to which a first scan signal is transmitted.

In the plurality of second gate blocks GB2, the plurality of gate lines GL extending in the row direction and a power line VDDL extending in a column direction so as to intersect the plurality of gate lines GL may be disposed.

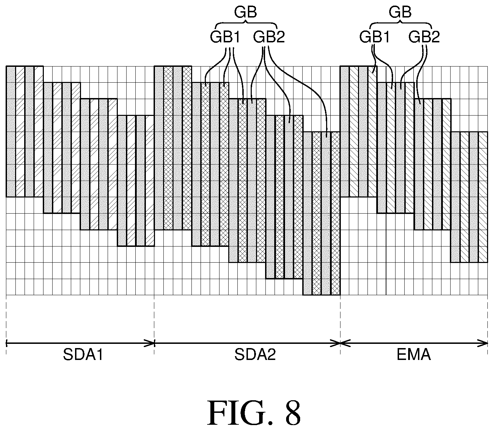

FIG. 8 is a schematic view for explaining a second area of FIG. 1. In FIG. 8, for the convenience of description, only a first scan driver area SDA1, a second scan driver area SDA2, an emission driver area EMA, and a plurality of gate blocks GB disposed in a second area A2 of FIG. 1 are illustrated. Hereinafter, the remaining configurations excluding a plurality of gate blocks GB are the same as those of FIG. 6 so that a description will be omitted.

Referring to FIG. 8, the second area A2 may be an area smaller than the plurality of first areas A1 due to the notch area NTA. Therefore, the number of the plurality of gate blocks GB disposed in each of the first scan driver area SDA1, the second scan driver area SDA2, and the emission driver area EMA may be smaller than that of the first area A1. For example, in each of the first scan driver area SDA1, the second scan driver area SDA2, and the emission driver area EMA disposed in the second area A2, two first gate blocks GB1 and two second gate blocks GB2 may be disposed to extend in the column direction. Even though in FIG. 6, one first gate block GB1 is omitted as compared with FIG. 4, the number of the first gate blocks GB1 and the second gate blocks GB2 disposed in the second area A2 may vary depending on the area and the design, but is not limited thereto.

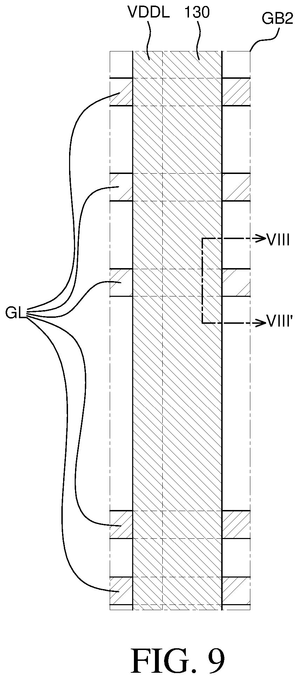

FIG. 9 is an enlarged plan view of one of gate blocks of FIG. 8. In FIG. 9, a part of the second gate block GB2, among the plurality of gate blocks GB of FIG. 8 is enlarged.

Referring to FIG. 9, in the second gate block GB2 disposed in the second area A2, a plurality of gate lines GL, a high potential power line VDDL, and a first compensation pattern 130 may be disposed.

The plurality of gate lines GL extends in the row direction in the second gate block GB2 and is spaced apart from each other in the column direction to be disposed in parallel.

The high potential power line VDDL extends in the column direction in the second gate block GB2 to intersect the plurality of gate lines GL.

The first compensation pattern 130 extends in the column direction in the second gate block GB2 to overlap the plurality of gate lines GL. The first compensation pattern 130 may extend in the row direction from the high potential power line VDDL and may be integrally formed with the high potential power line VDDL. Therefore, the first compensation pattern may serve as a high potential power line and the high potential power line may also serve as the first compensation pattern.

The first compensation pattern 130 may be formed with a constant width from an upper end to a lower end of the second gate block GB2. The width of the high potential power line VDDL and the first compensation pattern 130 disposed in the second gate block GB2 of the second area A2 may be larger than a width of the high potential power line VDDL disposed in the second gate block GB2 of the first area A1. That is, an area that the high potential power line VDDL and the first compensation pattern 130 disposed in the second gate block GB2 of the second area A2 overlap the plurality of gate lines GL may be larger than an area that the high potential power line VDDL disposed in the second gate block GB2 of the first area A1 and the plurality of gate lines GL overlap.

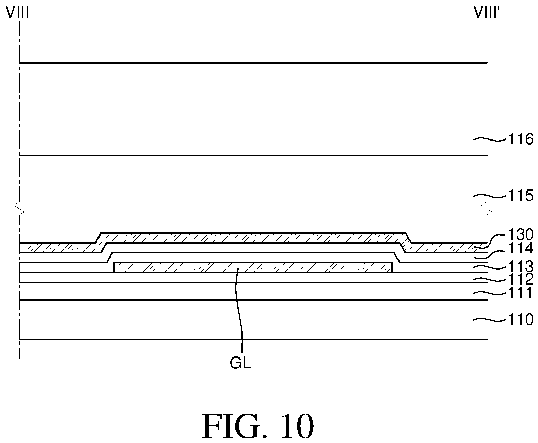

FIG. 10 is a cross-sectional view taken along the line VIII-VIII' of FIG. 9. In FIG. 10, for the convenience of description, only a substrate 110, a buffer layer 111, a gate insulating layer 112, a gate line GL, a first interlayer insulating layer 113, a second interlayer insulating layer 114, a first compensation pattern 130, a first planarization layer 115, and a second planarization layer 116 are illustrated. Hereinafter, the remaining configurations excluding the gate line GL and the first compensation pattern 130 are the same as those of FIG. 4 so that a detailed description will be omitted.

Referring to FIG. 10, the gate line GL may be disposed on the gate insulating layer 112.

The gate line GL may be formed on the same layer with the same material as the first gate electrode GE1 of the first transistor T1. For example, the gate line GL may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The first compensation pattern 130 may be disposed on the second interlayer insulating layer 114.

The first compensation pattern 130 may be disposed on the second interlayer insulating layer 114 so as to overlap the gate line GL. The first compensation pattern 130 may be formed on the same layer with the same material as the first source electrode SE1 and the first drain electrode DE1 of the first transistor T1. For example, the first compensation pattern 130 may be formed as a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

In the display apparatus of the related art, the substrate is configured as a rectangular substrate without having a side with a heterogeneous structure so that an output characteristic of the gate signal output from the gate driver is the same in all the positions of the active area. However, in the case of the heterogeneous display apparatus in which at least one or more of four sides of the substrate has a heterogeneous structure, rather than the rectangular substrate, the output characteristic of the gate signal is the same in an area without a heterogeneous structure. However, in an area with the heterogeneous structure, the output characteristic of the gate signal varies as compared with the area without a heterogeneous structure so that there is a problem in that the luminance is not uniform.

Therefore, in the display apparatus 100 according to the exemplary embodiment of the present disclosure, the active area AA is divided into a plurality of first areas A1 and at least one second area A2 disposed so as to correspond to the notch area. In each of the first area A1 and the second area A2, a plurality of gate blocks GB1 and GB2 in which the gate drivers are separately disposed is disposed. In the second area A2 which is smaller than the first area A1 due to the notch area, a smaller number of gate blocks GB1 and GB2 than the first area A1 is disposed so that the output characteristic of the gate signal is different. Accordingly, the first compensation pattern 130 is disposed in at least one gate block GB2, among the plurality of gate blocks GB1 and GB2 disposed in the second area A2, so as to overlap the gate line GL to form a capacitor between the gate line GL and the first compensation pattern 130. Therefore, an RC delay for a gate signal output from the plurality of gate blocks GB1 and GB2 disposed in the second area A2 may be compensated. That is, the output characteristic of the gate signal output from the plurality of gate blocks GB1 and GB2 disposed in the second area A2 may become equal to the output characteristic of the gate signal output from the plurality of gate blocks GB1 and GB2 disposed in the first area A1. Accordingly, in the display apparatus 100 according to the exemplary embodiment of the present disclosure, the RC delay for the gate signal changed due to the heterogeneous structure is compensated to be equal to that in an area without a heterogeneous structure to reduce the luminance irregularity and improve the display quality.

Further, when the compensation pattern for compensating for the RC delay deviation due to the gate driver which outputs a gate signal and the heterogeneous structure is disposed in the non-active area, there is a problem in that the area of the non-active area is increased to increase the bezel area.

Therefore, in the display apparatus 100 according to the exemplary embodiment of the present disclosure, the plurality of gate blocks GB1 and GB2 in which the gate drivers are separately disposed is distributed in the active area AA. Further, the first compensation pattern 130 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 100 according to the exemplary embodiment of the present disclosure, the gate driver and the first compensation pattern 130 are disposed in the active area to reduce or minimize the bezel area.

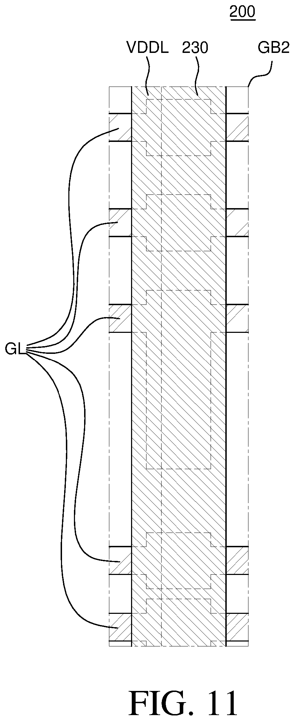

FIG. 11 is an enlarged plan view of one of gate blocks of a display apparatus according to another exemplary embodiment of the present disclosure. In FIG. 11, a part of a second gate block GB2, among a plurality of gate blocks GB of a display apparatus 200 according to another exemplary embodiment of the present disclosure is enlarged.

Referring to FIG. 11, in the second gate block GB2 disposed in the second area A2, a high potential power line VDDL, a first compensation pattern 230, and a plurality of gate lines GL may be disposed.

The high potential power line VDDL extends in the column direction in the second gate block GB2 to intersect the plurality of gate lines GL.

The first compensation pattern 230 extends in the column direction in the second gate block GB2 to overlap the plurality of gate lines GL. The first compensation pattern 230 may extend in the row direction from the high potential power line VDDL and may be integrally formed with the high potential power line VDDL. Therefore, the first compensation pattern may serve as a high potential power line and the high potential power line may also serve as the first compensation pattern.

The first compensation pattern 230 may be formed with a constant width from an upper end to a lower end of the second gate block GB2. The width of the high potential power line VDDL and the first compensation pattern 230 disposed in the second gate block GB2 of the second area A2 may be larger than a width of the high potential power line VDDL disposed in the second gate block GB2 of the first area A1. That is, an area that the high potential power line VDDL and the first compensation pattern 230 disposed in the second gate block GB2 of the second area A2 overlap the plurality of gate lines GL may be larger than an area that the high potential power line VDDL disposed in the second gate block GB2 of the first area A1 and the plurality of gate lines GL overlap.

The plurality of gate lines GL extends in the row direction in the second gate block GB2 and is spaced apart from each other in the column direction to be disposed in parallel. A width of a part of the plurality of gate lines GL which overlaps the first compensation pattern 230 may be larger than a width of a part of the plurality of gate lines GL which does not overlap the first compensation pattern 230. For example, the part of the plurality of gate lines GL which overlaps the high potential power line VDDL and the first compensation pattern 230 may be larger than a width of the part which does not overlap the high potential power line VDDL and the first compensation pattern 230. For example, the part of the plurality of gate lines GL having a large width may be a part formed by extending a part of the plurality of gate lines GL which overlaps the high potential power line VDDL and the first compensation pattern 230 in the column direction.

Further, the part of the plurality of gate lines GL having a larger width may vary depending on an output of the gate driver connected to each gate line GL. For example, when an output of the gate driver connected to the gate line GL is larger than an output of the gate driver connected to another gate line GL, a width of the part of the gate line GL which overlaps the high potential power line VDDL and the first compensation pattern 230 may be larger than a width of the part of the other gate line GL which overlaps the high potential power line VDDL and the first compensation pattern 230.

In the display apparatus 200 according to another exemplary embodiment of the present disclosure, the first compensation pattern 230 is disposed in at least one gate block GB2, among the plurality of gate blocks GB1 and GB2 disposed in the second area A2 so as to overlap the gate line GL. Therefore, a capacitor is formed between the gate line GL and the first compensation pattern 230 to compensate for the RC delay for the gate signal output from the plurality of gate blocks GB1 and GB2 disposed in the second area A2. Accordingly, in the display apparatus 200 according to another exemplary embodiment of the present disclosure, the RC delay for the gate signal changed due to the heterogeneous structure is compensated to be equal to that in an area without a heterogeneous structure to reduce the luminance irregularity and improve the display quality.

Therefore, in the display apparatus 200 according to another exemplary embodiment of the present disclosure, the plurality of gate blocks GB1 and GB2 in which the gate drivers are separately disposed is distributed in the active area AA. Further, a first compensation pattern 230 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 200 according to another exemplary embodiment of the present disclosure, the gate driver and the first compensation pattern 230 are disposed in the active area to reduce or minimize the bezel area.

In the display apparatus 200 according to another exemplary embodiment of the present disclosure, a width of a part of the plurality of gate lines GL which overlaps the first compensation pattern 230 may be larger than a width of a part of the plurality of gate lines GL which does not overlap the first compensation pattern 230. At this time, the width of the part which overlaps the first compensation pattern 230 may be designed to be different according to the output of the gate driver to which the gate line GL is connected. Therefore, the RC delay may be compensated in accordance with an output characteristic of the gate signal output from the plurality of gate blocks GB1 and GB2 disposed in the second area A2. Accordingly, in the display apparatus 200 according to another exemplary embodiment of the present disclosure, the RC delay may be compensated according to an output of the gate driver to which the gate line GL is connected to improve a degree of freedom of design and improve the display quality.

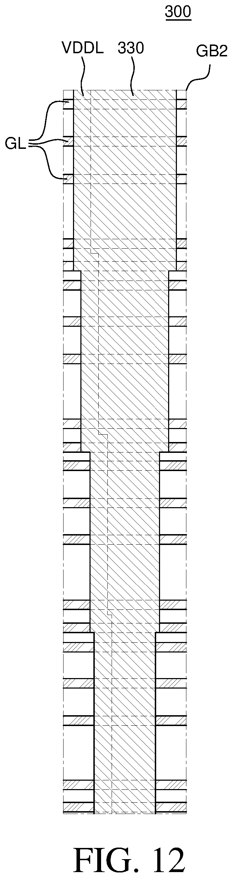

FIG. 12 is an enlarged plan view of one of gate blocks of a display apparatus according to still another exemplary embodiment of the present disclosure.

In FIG. 12, a part of a second gate block GB2, among a plurality of gate blocks GB of a display apparatus 300 according to still another exemplary embodiment of the present disclosure is enlarged.

Referring to FIG. 12, in the second gate block GB2 disposed in the second area A2, a high potential power line VDDL, a first compensation pattern 230, and a plurality of gate lines GL may be disposed.

The plurality of gate lines GL extends in the row direction in the second gate block GB2 and is spaced apart from each other in the column direction to be disposed in parallel. The plurality of gate lines GL may have a constant width.

The high potential power line VDDL extends in the column direction in the second gate block GB2 to intersect the plurality of gate lines GL. The high potential power line VDDL may be formed with a constant width from an upper end to a lower end of the second gate block GB2.

The first compensation pattern 330 extends in the column direction in the second gate block GB2 to overlap the plurality of gate lines GL. The first compensation pattern 330 may extend in the row direction from the high potential power line VDDL and may be integrally formed with the high potential power line VDDL.

The width of the high potential power line VDDL and the first compensation pattern 230 disposed in the second gate block GB2 of the second area A2 may be larger than a width of the high potential power line VDDL disposed in the second gate block GB2 of the first area A1. That is, an area that the high potential power line VDDL and the first compensation pattern 230 disposed in the second gate block GB2 of the second area A2 overlap the plurality of gate lines GL may be larger than an area that the high potential power line VDDL disposed in the second gate block GB2 of the first area A1 and the plurality of gate lines GL overlap.

In the meantime, a width of the first compensation pattern 330 may vary depending on the position. The high potential power line VDDL is constant so that a summed width of the high potential power line VDDL and the first compensation pattern 330 may vary depending on the position. The width of the first compensation pattern 330 may vary according to the output of the gate driver to which each gate line GL is connected. For example, when an output of the gate driver connected to the gate line GL is larger than an output of the gate driver connected to another gate line GL, the width of the first compensation pattern 330 overlapping the corresponding gate line GL may be larger than a width of the first compensation pattern 330 overlapping another gate line GL. Even though in FIG. 12, it is illustrated that the widths of the high potential power line VDDL and the first compensation pattern 330 are narrower to the center toward the bottom, it is not limited thereto.

Accordingly, in a display apparatus 300 according to still another exemplary embodiment of the present disclosure, the first compensation pattern 330 is disposed in at least one gate block GB2, among the plurality of gate blocks GB1 and GB2 disposed in the second area A2, so as to overlap the gate line GL to form a capacitor between the gate line GL and the first compensation pattern 330. Therefore, an RC delay for a gate signal output from the plurality of gate blocks GB1 and GB2 disposed in the second area A2 may be compensated. Accordingly, in the display apparatus 300 according to still another exemplary embodiment of the present disclosure, the RC delay for the gate signal changed due to the heterogeneous structure is compensated to be equal to that in an area without a heterogeneous structure to reduce the luminance irregularity and improve the display quality.

Therefore, in the display apparatus 300 according to still another exemplary embodiment of the present disclosure, the plurality of gate blocks GB1 and GB2 in which the gate drivers are separately disposed is distributed in the active area AA. Further, a first compensation pattern 330 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 300 according to still another exemplary embodiment of the present disclosure, the gate driver and the first compensation pattern 330 are disposed in the active area to reduce or minimize the bezel area.

In the display apparatus 300 according to still another exemplary embodiment of the present disclosure, the plurality of gate lines GL has a constant width and a width of the first compensation pattern 330 which overlaps the plurality of gate lines GL may vary according to the position. Therefore, a capacitor may be formed between the gate line GL and the first compensation pattern 330 in various forms to compensate for the RC delay in accordance with an output characteristic of the gate signal output from the plurality of gate blocks GB1 and GB2 disposed in the second area A2. Accordingly, in the display apparatus 300 according to still another exemplary embodiment of the present disclosure, the RC delay may be compensated according to an output of the gate driver to which the gate line GL is connected to improve a degree of freedom of design and improve the display quality.

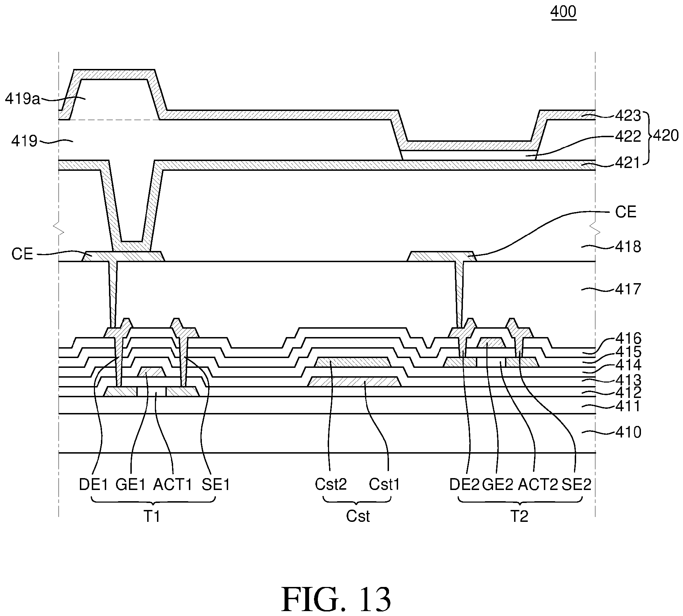

FIG. 13 is a cross-sectional view of a display apparatus according to still another exemplary embodiment of the present disclosure. In FIG. 13, for the convenience of description, among various components of the display apparatus 400 according to an exemplary embodiment of the present disclosure, only a substrate 410, a first transistor T1, a storage capacitor Cst, a first buffer layer 411, a first gate insulating layer 412, a first interlayer insulating layer 413, a second buffer layer 414, a second transistor T2, a second gate insulating layer 415, a second interlayer insulating layer 416, a first planarization layer 417, a connection electrode CE, a second planarization layer 418, a light emitting diode 420, a bank layer 419, and a spacer 419a are illustrated.

Referring to FIG. 13, the display apparatus 400 according to still another exemplary embodiment of the present disclosure includes a substrate 410, a first transistor T1, a storage capacitor Cst, a first buffer layer 411, a first gate insulating layer 412, a first interlayer insulating layer 413, a second buffer layer 414, a second transistor T2, a second gate insulating layer 415, a second interlayer insulating layer 416, a first planarization layer 417, a connection electrode CE, a second planarization layer 418, a light emitting diode 420, and a bank layer 419.

The substrate 410 is a base member which supports various components of the display apparatus 400 and may be configured by an insulating material. For example, the substrate may be formed of glass or a plastic material, but is not limited thereto.

The first buffer layer 411 may be disposed on the substrate 410. The first buffer layer 411 may be formed on an entire surface of the substrate 410. The first buffer layer 411 may be formed by a single layer of silicon nitride (SiNx) or silicon oxide (SiOx) or a multi-layer thereof. The first buffer layer 411 may enhance an adhesiveness between layers formed on the first buffer layer 411 and the substrate 410. The first buffer layer 411 is not an essential component and may be omitted based on a type or a material of the substrate 410 and a structure and a type of a transistor.

The first transistor T1 may be disposed on the first buffer layer 411. The first transistor T1 may include a first active layer ACT1, a first gate electrode GE1, a first source electrode SE1, and a first drain electrode DE1. A first active layer ACT1 of the first transistor T1 may be disposed on the first buffer layer 411.

The first active layer ACT1 may be formed of a semiconductor material such as an oxide semiconductor, amorphous silicon, or polysilicon, but is not limited thereto.

The first gate insulating layer 412 may be disposed on the first active layer ACT1 of the first transistor T1. The first gate insulating layer 412 may be configured as a single layer of silicon nitride (SiNx) or silicon oxide (SiOx) or a multi-layer thereof. In the first gate insulating layer 412, a contact hole through which each of the first source electrode SE1 and the first drain electrode DE1 of the first transistor T1 is connected to the first active layer ACT1 of the first transistor T1 may be formed.

The first gate electrode GE1 of the first transistor T1 may be disposed on the first gate insulating layer 412. The first gate electrode GE1 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof. The first gate electrode GE1 may be formed on the first gate insulating layer 412 so as to overlap the first active layer ACT1 of the first transistor T1.

The first interlayer insulating layer 413 may be disposed on the first gate insulating layer 412 and the first gate electrode GE1. The first interlayer insulating layer 413 may be configured by a single layer of silicon nitride (SiNx) or silicon oxide (SiOx) or a multi-layer thereof. A contact hole may be formed in the first interlayer insulating layer 413 to expose the first active layer ACT1 of the first transistor T1.

The second buffer layer 414 may be disposed on the first interlayer insulating layer 413. The second buffer layer 414 may be formed on an entire surface of the substrate 410. The second buffer layer 414 may be formed by a single layer of silicon nitride (SiNx) or silicon oxide (SiOx) or a multi-layer thereof. A contact hole may be formed in the second buffer layer 414 to expose the first active layer ACT1 of the first transistor T1.

The second transistor T2 may be disposed on the second buffer layer 414. The second transistor T2 may include a second active layer ACT2, a second gate electrode GE2, a second source electrode SE2, and a second drain electrode DE2. The second active layer ACT2 of the second transistor T2 may be disposed on the second buffer layer 414.

The second active layer ACT2 may be formed of an oxide semiconductor. For example, the second active layer ACT2 may be formed of metal oxide and for example, may be formed of various metal oxides such as indium-gallium-zinc-oxide (IGZO). Under assumption that the second active layer ACT2 of the second transistor T2 is formed of IGZO, among various metal oxides, it has been described that the active layer is formed based on the IGZO layer, but it is not limited thereto. Therefore, the active layer may be formed of another metal oxide such as indium-zinc-oxide (IZO), indium-gallium-tin-oxide (IGTO), or indium-gallium-oxide (IGO), other than IGZO.

The second gate insulating layer 415 may be disposed on the second active layer ACT2 of the second transistor T2. The second gate insulating layer 415 may be configured by a single layer of silicon nitride (SiNx) or silicon oxide (SiOx) or a multi-layer thereof. In the second gate insulating layer 415, a contact hole through which each of the second source electrode SE2 and the second drain electrode DE2 of the second transistor T2 is connected to the second active layer ACT2 of the second transistor T2 may be formed.

The second gate electrode GE2 of the second transistor T2 may be disposed on the second gate insulating layer 415. The second gate electrode GE2 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof. The second gate electrode GE2 may be formed on the second gate insulating layer 415 so as to overlap the second active layer ACT2 of the second transistor T2. A contact hole for exposing the first active layer ACT1 of the first transistor T1 and the second active layer ACT2 of the second transistor T2 may be formed in the second gate insulating layer 415.

The second interlayer insulating layer 416 may be disposed on the second gate insulating layer 415 and the second gate electrode GE2. The second interlayer insulating layer 416 may be configured by a single layer of silicon nitride (SiNx) or silicon oxide (SiOx) or a multi-layer thereof. A contact hole for exposing the first active layer ACT1 of the first transistor T1 and the second active layer ACT2 of the second transistor T2 may be formed in the second interlayer insulating layer 416.

A first source electrode SE1 and a first drain electrode DE1 of the first transistor T1 and a second source electrode SE2 and a second drain electrode DE2 of the second transistor T2 may be disposed on the second interlayer insulating layer 416.

The first source electrode SE1 and the first drain electrode DE1 of the first transistor T1 may be connected to the first active layer ACT1 of the first transistor T1 through contact holes formed in the first gate insulating layer 412, the first interlayer insulating layer 413, the second buffer layer 414, the second gate insulating layer 415, and the second interlayer insulating layer 416. Therefore, the first source electrode SE1 of the first transistor T1 may be connected to a first source region of the first active layer ACT1 through the contact holes formed in the first gate insulating layer 412, the first interlayer insulating layer 413, the second buffer layer 414, the second gate insulating layer 415, and the second interlayer insulating layer 416. The first drain electrode DE1 of the first transistor T1 may be connected to a first drain region of the first active layer ACT1 through the contact holes formed in the first gate insulating layer 412, the first interlayer insulating layer 413, the second buffer layer 414, the second gate insulating layer 415, and the second interlayer insulating layer 416.

The second source electrode SE2 and the second drain electrode DE2 of the second transistor T2 may be connected to the second active layer ACT2 of the second transistor T2 through contact holes formed in the second gate insulating layer 415 and the second interlayer insulating layer 416. Therefore, the second source electrode SE2 of the second transistor T2 may be connected to a second source region of the second active layer ACT2 through the contact holes formed in the second gate insulating layer 415 and the second interlayer insulating layer 416. Further, the second drain electrode DE2 of the second transistor T2 may be connected to a second drain region of the second active layer ACT2 through the contact holes formed in the second gate insulating layer 415 and the second interlayer insulating layer 416.

The storage capacitor Cst may include a first capacitor electrode Cst1 and a second capacitor electrode Cst2.

The first capacitor electrode Cst1 may be disposed on the gate insulating layer 112. The first capacitor electrode Cst1 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof. The first capacitor electrode Cst1 may be formed of the same material as the first gate electrode GE1, but is not limited thereto.

The second capacitor electrode Cst2 may be disposed on the first interlayer insulating layer 113. The second capacitor electrode Cst2 may be disposed on the first interlayer insulating layer 113 so as to overlap the first capacitor electrode Cst1. For example, the second capacitor electrode Cst2 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

A passivation layer may be disposed on the first source electrode SE1 and the first drain electrode DE1 of the first transistor T1 and the second source electrode SE2 and the second drain electrode DE2 of the second transistor T2, and the second interlayer insulating layer 416. The passivation layer is an insulating layer which protects elements therebelow and may be configured by a single layer of silicon nitride (SiNx) or silicon oxide (SiOx) or a multi-layer thereof.

The first planarization layer 417 may be disposed on the second interlayer insulating layer 416. The first planarization layer 417 is provided to relieve a step of a lower structure. The first planarization layer may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

The connection electrode CE may be disposed on the first planarization layer 417. The connection electrode CE may be electrically connected to each of the first drain electrode DE1 of the first transistor T1 and the second drain electrode DE2 of the second transistor T2 through a contact hole formed in the first planarization layer 417. The connection electrode CE may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The second planarization layer 418 may be disposed on the connection electrode CE and the first planarization layer 417. The second planarization layer 418 is provided to relieve a step of a lower structure. The second planarization layer may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

The light emitting diode 420 may be disposed on the second planarization layer 418. The light emitting diode 420 may include a first electrode 421, an emission structure 422, and a second electrode 423.

The first electrode 421 may be disposed on the second planarization layer 418. The first electrode 421 is an anode electrode and may be electrically connected to the first drain electrode DE1 of the first transistor T1 through a contact hole.

The bank layer 419 may be disposed on the first electrode 421 and the second planarization layer 418.

An opening may be formed in the bank layer 419 to expose the first electrode 421. Since the bank layer 419 may define an emission area of the display apparatus 400, the bank layer 419 may also be referred to as a pixel definition layer. The bank layer 419 may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

A spacer 419a may be further disposed on the bank layer 419. The spacer 419a may serve to support a mask when the mask is aligned on the bank layer 419 in a process for depositing the first electrode 421. The spacer 419a may be integrally configured with the bank layer 419. The spacer 419a may be formed of an organic material, such as acrylic resin, epoxy resin, phenol resin, polyamide-based resin, polyimide-based resin, unsaturated polyester-based resin, polyphenylene-based resin, polyphenylene sulfide-based resin, benzocyclobutene, or photoresist, but is not limited thereto.

The emission structure 422 may be disposed on the first electrode 421. The emission structure 422 may include a material which emits light of a specific color. For example, the emission structure 422 may include an emission material which emits any one of red light, green light, and blue light. Specifically, the emission structure 422 may include at least one of a hole injection layer (HIL), a hole transport layer (HTL), an emission layer (EML), an electron transport layer (ETL), and an electron injection layer (EIL). Some components of the emission structure 422 may be omitted depending on the structure or the characteristic of the display apparatus 400.

The second electrode 423 may be further disposed on the emission structure 422, the bank layer 419, and the spacer 419a. The second electrode 423 is a cathode electrode and may be disposed on the emission structure 422 so as to be opposite to the first electrode 421 with the emission structure 422 therebetween. The second electrode 423 supplies electrons to the emission structure 422. The second electrode 423 may be formed of a transparent conductive oxide such as indium tin oxide or indium zinc oxide or a transparent conductive material such as ytterbium (Yb), but is not limited thereto.

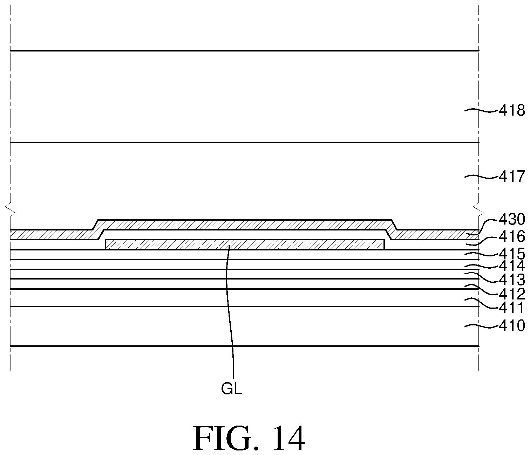

FIG. 14 is a cross-sectional view of one of gate blocks of a display apparatus according to still another exemplary embodiment of the present disclosure. FIG. 14 is a cross-sectional view for a second gate block GB2, among gate blocks GB of a display apparatus 400 according to still another exemplary embodiment of the present disclosure. FIG. 14 is a cross-section view along the same position as FIG. 10.

In FIG. 14, for the convenience of description, only a substrate 410, a first buffer layer 411, a first gate insulating layer 412, a first interlayer insulating layer 413, a second buffer layer 414, a second gate insulating layer 415, a gate line GL, a second interlayer insulating layer 416, a first compensation pattern 430, a first planarization layer 417, and a second planarization layer 418 are illustrated. Hereinafter, the remaining configurations excluding the gate line GL and the first compensation pattern 430 are the same as those of FIG. 11 so that a detailed description will be omitted.

Referring to FIG. 14, the gate line GL may be disposed on the second gate insulating layer 415.

The gate line GL may be formed on the same layer with the same material as the second gate electrode GE2 of the second transistor T2. For example, the gate line GL may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The first compensation pattern 430 may be disposed on the second interlayer insulating layer 416.

The first compensation pattern 430 may be disposed on the second interlayer insulating layer 416 so as to overlap the gate line GL. The first compensation pattern 430 overlaps the gate line GL to form a capacitor between the gate line GL and the first compensation pattern. The first compensation pattern 430 may be formed on the same layer with the same material as the first source electrode SE1 and the first drain electrode DE1 of the first transistor T1 and the second source electrode SE2 and the second drain electrode DE2 of the second transistor T2. For example, the first compensation pattern 430 may be formed as a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

Accordingly, in a display apparatus 400 according to still another exemplary embodiment of the present disclosure, the first compensation pattern 430 is disposed in at least one gate block GB2, among the plurality of gate blocks GB1 and GB2 disposed in the second area A2, so as to overlap the gate line GL to form a capacitor between the gate line GL and the first compensation pattern 430. Therefore, an RC delay for a gate signal output from the plurality of gate blocks GB1 and GB2 disposed in the second area A2 may be compensated. Accordingly, in the display apparatus 400 according to still another exemplary embodiment of the present disclosure, the RC delay for the gate signal changed due to the heterogeneous structure is compensated to be equal to that in an area without a heterogeneous structure to reduce the luminance irregularity and improve the display quality.

Therefore, in the display apparatus 400 according to still another exemplary embodiment of the present disclosure, the plurality of gate blocks GB1 and GB2 in which the gate drivers are separately disposed is distributed in the active area AA. Further, a first compensation pattern 430 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 400 according to still another exemplary embodiment of the present disclosure, the gate driver and the first compensation pattern 430 are disposed in the active area to reduce or minimize the bezel area.

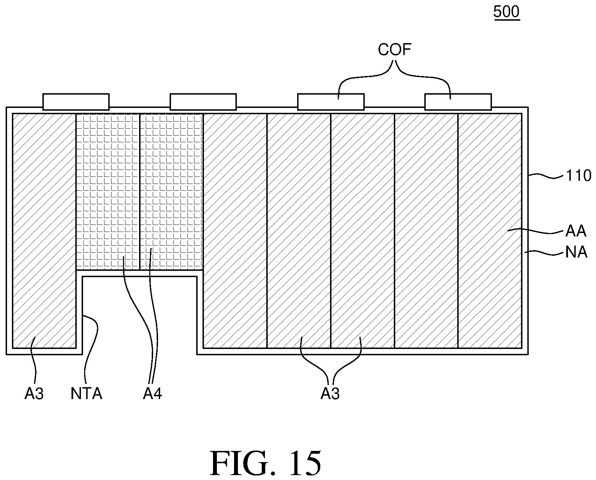

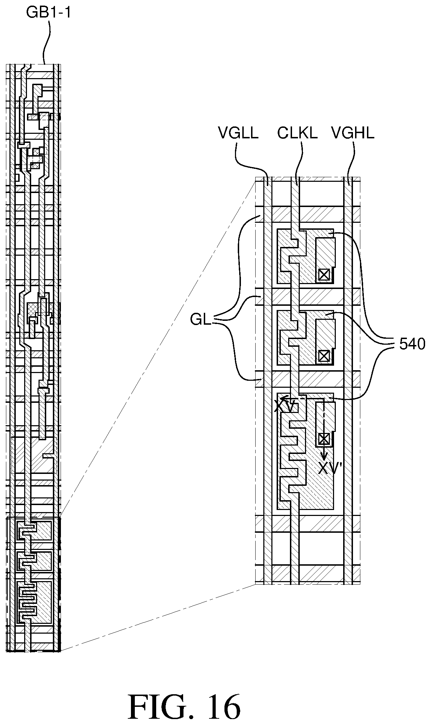

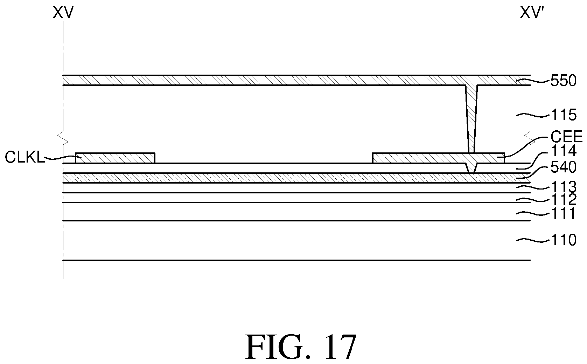

FIG. 15 is an exemplary plan view of a display apparatus according to still another exemplary embodiment of the present disclosure and FIG. 16 is a plan view of one of gate blocks of a fourth area of FIG. 15. FIG. 17 is a cross-sectional view taken along the line XV-XV' of FIG. 16.

For the convenience of description, in FIG. 15, among various components of the display apparatus 500, only a substrate 110 and a plurality of flexible films COF are illustrated. In FIG. 15, the remaining configurations excluding a plurality of third areas A3 and a plurality of fourth areas A4 of the active area AA are the same as those in FIG. 1 so that a detailed description will be omitted.

Referring to FIG. 15, the active area AA may include a plurality of third areas A3 and a plurality of fourth areas A4. Each of the plurality of third areas A3 and a plurality of fourth areas A4 may be areas in which the gate drivers are distributed. The plurality of third areas A3 is areas having a first width in the column direction and the plurality of fourth areas A4 is areas which are disposed so as to correspond to the notch area NTA and has a second width smaller than the first width of the plurality of third areas A3. For example, the fourth area A4 may be an area having a width in the column direction smaller than a width of the third area A3 in the column direction. The plurality of third areas A3 may be remaining areas excluding the fourth area A4.

In FIG. 16, only a 1-1-th gate block GB1-1, among the plurality of gate blocks GB disposed in the fourth area A4, is illustrated. In FIG. 16, the remaining configuration excluding the clock line CLKL and the second compensation pattern 540 are the same as those in FIG. 5 so that a detailed description will be omitted.

Referring to FIG. 16, the clock line CLKL may be connected to the plurality of gate blocks GB. In a 1-1-th gate block GB1-1, among the plurality of gate blocks GB, a clock line CLKL which extends in the column direction to transmit a clock signal may be disposed. The clock line CLKL may be disposed so as to intersect the plurality of gate lines GL disposed in the row direction.

The second compensation pattern 540 may overlap the clock line CLKL. The second compensation pattern 540 may be disposed between the plurality of gate lines GL of the 1-1-th gate block GB1-1. The second compensation pattern 540 may be disposed below the clock line CLKL and may be disposed so as to overlap the clock line CLKL. Even though in FIG. 16, it is illustrated that the second compensation pattern is disposed below the clock line, it is not limited thereto and the second compensation pattern may be disposed above the clock line CLKL to overlap the clock line CLKL. For the convenience of design, the second compensation pattern 540 may be disposed in a position adjacent to the notch area NTA. A constant voltage may be applied to the second compensation pattern 540. For example, the second compensation pattern 540 is electrically connected to one of a low potential power line VSSL to which a low potential power is applied and a high potential power line VDDL to which a high potential power is applied to be applied with a low potential power or a high potential power.

In the meantime, the second compensation pattern 540 has a constant width and a length of the clock line CLKL overlapping the second compensation pattern may vary according to the position. The second compensation pattern 540 is disposed between the plurality of gate lines GL, the gate low voltage line VGLL, and the gate high voltage line VGHL to have a constant width.

A length of the clock line CLKL disposed in the fourth area A4 may be equal to a length of the clock line CLKL disposed in the third area A3. For example, a clock line CLKL disposed in an area adjacent to the notch area NTA, among clock lines CLKL disposed in the fourth area A4, may have a zigzag pattern. For example, a part of a clock line CLKL overlapping the second compensation pattern 540, among clock lines CLKL disposed in the fourth area A4, may have a zigzag pattern. Therefore, even though a width of the fourth area A4 is smaller than a width of the third area A3, an entire length of the clock line CLKL disposed in the fourth area A4 may be equal to the entire length of the clock line CLKL disposed in the third area A3.

In FIG. 17, for the convenience of description, only a substrate 110, a buffer layer 111, a gate insulating layer 112, a first interlayer insulating layer 113, a second compensation pattern 540, a second interlayer insulating layer 114, a clock line CLKL, a center electrode CEE, a first planarization layer 115, and a third compensation pattern 550 are illustrated. Hereinafter, the remaining configurations excluding the second compensation pattern 540, the clock line CLKL, the center electrode CEE, and the third compensation pattern 550 are the same as those in FIG. 4 so that a detailed description will be omitted.

Referring to FIG. 17, the second compensation pattern 540 may be disposed between the first interlayer insulating layer 113 and the second interlayer insulating layer 114.

The second compensation pattern 540 may be formed on the same layer with the same material as the second capacitor electrode Cst2. For example, the second compensation pattern 540 may be formed as a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The clock line CLKL may be disposed on the second interlayer insulating layer 114.

The clock line CLKL may be disposed on the second interlayer insulating layer 114 so as to overlap the second compensation pattern 540. The clock line CLKL may be formed on the same layer with the same material as the first source electrode SE1 and the first drain electrode DE1 of the first transistor T1. For example, the clock line CLKL may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The center electrode CEE may be disposed on the second interlayer insulating layer 114.

The center electrode CEE may be disposed on the same layer as the clock line CLKL and may be formed of the same material. The center electrode CEE may be electrically connected to the second compensation pattern 540 through a contact hole formed in the second interlayer insulating layer 114.

A third compensation pattern 550 may be disposed on the first planarization layer 115.

The third compensation pattern 550 may overlap the clock line CLKL. The third compensation pattern 550 may be electrically connected to the center electrode CEE through the contact hole formed in the first planarization layer 115. The third compensation pattern 550 may be disposed on the same layer as the connection electrode CE and may be formed of the same material. For example, the third compensation pattern 550 may be formed as a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

That is, the clock line CLKL overlaps the second compensation pattern 540 and the third compensation pattern 550 and the third compensation pattern 550 to which a constant voltage is applied may be electrically connected to the second compensation pattern 540 through the contact hole and the center electrode CEE. Therefore, a capacitor is formed between the clock line CLKL and the second compensation pattern 540 and a capacitor is formed between the clock line CLKL and the third compensation pattern 550 to delay the clock signal applied to the clock line CLKL.

Accordingly, in a display apparatus 500 according to still another exemplary embodiment of the present disclosure, the first compensation pattern 230 is disposed in at least one gate block GB2, among the plurality of gate blocks GB1 and GB2 disposed in the second area A2, so as to overlap the gate line GL to form a capacitor between the gate line GL and the first compensation pattern 230. Therefore, an RC delay for a gate signal output from the plurality of gate blocks GB1 and GB2 disposed in the second area A2 may be compensated. Accordingly, in the display apparatus 500 according to still another exemplary embodiment of the present disclosure, the RC delay for the gate signal changed due to the heterogeneous structure is compensated to be equal to that in an area without a heterogeneous structure to reduce the luminance irregularity and improve the display quality.

Therefore, in the display apparatus 500 according to still another exemplary embodiment of the present disclosure, the plurality of gate blocks GB1 and GB2 in which the gate drivers are separately disposed is distributed in the active area AA. Further, a first compensation pattern 230 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 500 according to still another exemplary embodiment of the present disclosure, the gate driver and the first compensation pattern 230 are disposed in the active area to reduce or minimize the bezel area.

In the display apparatus of the related art, the substrate is configured as a rectangular substrate without having a side with a heterogeneous structure so that the same clock signal is supplied to the gate drivers disposed at the lowermost end of the active area. However, in the case of a heterogeneous display apparatus in which one or more sides among four sides of a substrate which is not a rectangular substrate have a heterogeneous structure, a time when the clock signal is supplied to a gate driver disposed at the lowermost end of a third area A3 without a heterogeneous structure and a time when the clock signal is supplied to a gate driver disposed at the lowermost end of a fourth area A3 with a heterogeneous structure are different. Therefore, there is a problem in that the luminance is irregular.

Accordingly, in the display apparatus 500 according to still another exemplary embodiment of the present disclosure, the second compensation pattern 540 and the third compensation pattern 550 are disposed to overlap a clock line CLKL disposed in at least one gate block GB1-1, among a plurality of gate blocks GB disposed in the fourth area A4. Therefore, a capacitor is formed between the clock line CLKL and the second compensation pattern 540 and a capacitor is formed between the clock line CLKL and the third compensation pattern 550 to compensate for the RC delay of the clock signal which is transmitted through the clock line CLKL disposed in the fourth area A4. That is, the clock signal which is transmitted through the clock line CLKL disposed in the fourth area A4 and the clock signal which is transmitted through the clock line CLKL disposed in the third area A3 may be equally transmitted to individual gate drivers. Accordingly, in the display apparatus 500 according to still another exemplary embodiment of the present disclosure, the RC delay difference for the clock signals according to the areas due to the heterogeneous structure is compensated to be equal to reduce the luminance irregularity and improve the display quality.

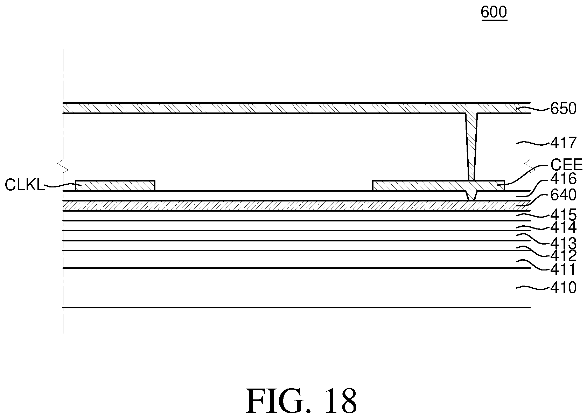

FIG. 18 is a cross-sectional view of one of gate blocks of a display apparatus according to still another exemplary embodiment of the present disclosure.

FIG. 18 is a cross-sectional view for a 1-1-th gate block GB1-1, among gate blocks GB of a display apparatus 600 according to still another exemplary embodiment of the present disclosure. FIG. 18 is a cross-section view along the same position as FIG. 17.

In FIG. 18, for the convenience of description, only a substrate 410, a first buffer layer 411, a first gate insulating layer 412, a first interlayer insulating layer 413, a second buffer layer 414, a second gate insulating layer 415, a second compensation pattern 640, a second interlayer insulating layer 416, a clock line CLKL, a center electrode CEE, a first planarization layer 417, and a third compensation pattern 650 are illustrated. Hereinafter, the remaining configurations excluding the second compensation pattern 640, the clock line CLKL, the center electrode CEE, and the third compensation pattern 650 are the same as those in FIG. 11 so that a detailed description will be omitted.

Referring to FIG. 18, the second compensation pattern 640 may be disposed on the second gate insulating layer 415.

The second compensation pattern 640 may be disposed on the same layer as the second gate electrode GE2 of the second transistor T2 and may be formed of the same material. For example, the second compensation pattern 640 may be formed as a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The clock line CLKL and the center electrode CEE may be disposed on the second interlayer insulating layer 416.

The clock line CLKL may be disposed on the second interlayer insulating layer 416 so as to overlap the second compensation pattern 640. The clock line CLKL overlaps the second compensation pattern 640 to form a capacitor between the second compensation pattern 640 and the clock line CLKL. The clock line CLKL may be disposed on the same layer as the first source electrode SE1 and the first drain electrode DE1 of the first transistor T1 and the second source electrode SE2 and the second drain electrode DE2 of the second transistor T2 and may be formed of the same material. For example, the clock line CLKL may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The center electrode CEE may be disposed on the same layer as the clock line CLKL and may be formed of the same material. The center electrode CEE may be electrically connected to the second compensation pattern 640 through a contact hole formed in the second interlayer insulating layer 416.

The third compensation pattern 650 may be disposed on the first planarization layer 417.

The third compensation pattern 650 may overlap the clock line CLKL. The third compensation pattern 650 may be electrically connected to the center electrode CEE through the contact hole formed in the first planarization layer 417. The third compensation pattern 650 may be disposed on the same layer as the connection electrode CE and may be formed of the same material. For example, the third compensation pattern 650 may be formed as a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

That is, the clock line CLKL overlaps the second compensation pattern 640 and the third compensation pattern 650 and the third compensation pattern 650 to which a constant voltage is applied may be electrically connected to the second compensation pattern 640 through the contact hole and the center electrode CEE. Therefore, a capacitor is formed between the clock line CLKL and the second compensation pattern 640 and a capacitor is formed between the clock line CLKL and the third compensation pattern 650 to delay the clock signal applied through the clock line CLKL.

Accordingly, in a display apparatus 600 according to still another exemplary embodiment of the present disclosure, the first compensation pattern 230 is disposed in at least one gate block GB2, among the plurality of gate blocks GB1 and GB2 disposed in the second area A2, so as to overlap the gate line GL to form a capacitor between the gate line GL and the first compensation pattern 230. Therefore, an RC delay for a gate signal output from the plurality of gate blocks GB1 and GB2 disposed in the second area A2 may be compensated. Accordingly, in the display apparatus 600 according to still another exemplary embodiment of the present disclosure, the RC delay for the gate signal changed due to the heterogeneous structure is compensated to be equal to that in an area without a heterogeneous structure to reduce the luminance irregularity and improve the display quality.

Therefore, in the display apparatus 600 according to still another exemplary embodiment of the present disclosure, the plurality of gate blocks GB1 and GB2 in which the gate drivers are separately disposed is distributed in the active area AA. Further, a first compensation pattern 230 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 600 according to still another exemplary embodiment of the present disclosure, the gate driver and the first compensation pattern 230 are disposed in the active area to reduce or minimize the bezel area.

Accordingly, in the display apparatus 600 according to still another exemplary embodiment of the present disclosure, the second compensation pattern 640 and the third compensation pattern 650 are disposed to overlap a clock line CLKL disposed in at least one gate block GB1-1, among a plurality of gate blocks GB disposed in the fourth area A4. Therefore, a capacitor is formed between the clock line CLKL and the second compensation pattern 640 and a capacitor is formed between the clock line CLKL and the third compensation pattern 650 to compensate for the RC delay of the clock signal which is transmitted through the clock line CLKL disposed in the fourth area A4. That is, the clock signal which is transmitted through the clock line CLKL disposed in the fourth area A4 and the clock signal which is transmitted through the clock line CLKL disposed in the third area A3 may be equally transmitted to individual gate drivers. Accordingly, in the display apparatus 600 according to still another exemplary embodiment of the present disclosure, the RC delay difference for the clock signals according to the areas due to the heterogeneous structure is compensated to be equal to reduce the luminance irregularity and improve the display quality.

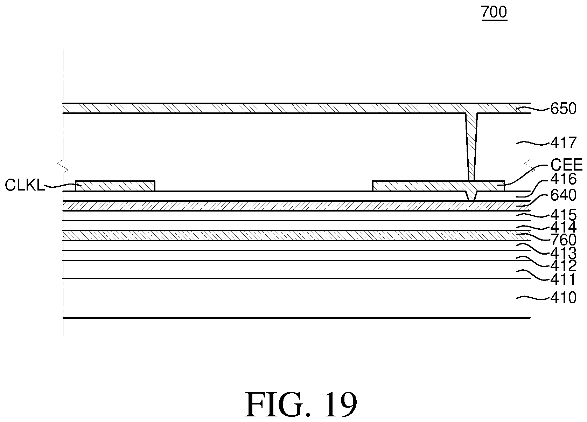

FIG. 19 is a cross-sectional view of one of gate blocks of a display apparatus according to still another exemplary embodiment of the present disclosure.

FIG. 19 is a cross-sectional view for a 1-1-th gate block GB1-1, among gate blocks GB of a display apparatus 700 according to still another exemplary embodiment of the present disclosure. FIG. 19 is a cross-section view along the same position as FIG. 17.

In FIG. 19, for the convenience of description, only a substrate 410, a first buffer layer 411, a first gate insulating layer 412, a first interlayer insulating layer 413, a fourth compensation pattern 760, a second buffer layer 414, a second gate insulating layer 415, a second compensation pattern 640, a second interlayer insulating layer 416, a clock line CLKL, a center electrode CEE, a first planarization layer 417, and a third compensation pattern 650 are illustrated. Hereinafter, the remaining configurations excluding the fourth compensation pattern 760 are the same as those in FIG. 16 so that a detailed description will be omitted.

Referring to FIG. 19, the fourth compensation pattern 760 may be disposed between the first interlayer insulating layer 413 and the second compensation pattern 640.

The fourth compensation pattern 760 may be disposed between the first interlayer insulating layer 413 and the second buffer layer 414. The fourth compensation pattern 760 may be disposed so as to overlap the second compensation pattern 640. The fourth compensation pattern 760 may be electrically connected to the second compensation pattern 640 through a contact hole formed in the second buffer layer 414.

The fourth compensation pattern 760 may be disposed on the same layer as the second capacitor electrode Cst2 of the storage capacitor Cst and may be formed of the same material. For example, the second capacitor electrode Cst2 may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

That is, the clock line CLKL may overlap the second compensation pattern 640, the third compensation pattern 650, and the fourth compensation pattern 760. The third compensation pattern 650 to which a constant voltage is applied may be electrically connected to the fourth compensation pattern 760 through the contact hole, the center electrode CEE, and the second compensation pattern 640. Therefore, a capacitor is formed between the clock line CLKL and the second compensation pattern 640, a capacitor is formed between the clock line CLKL and the third compensation pattern 650, and a capacitor is formed between the clock line CLKL and the fourth compensation pattern 760 to delay the clock signal applied through the clock line CLKL.

Accordingly, in a display apparatus 700 according to still another exemplary embodiment of the present disclosure, the first compensation pattern 230 is disposed in at least one gate block GB2, among the plurality of gate blocks GB1 and GB2 disposed in the second area A2, so as to overlap the gate line GL to form a capacitor between the gate line GL and the first compensation pattern 230. Therefore, an RC delay for a gate signal output from the plurality of gate blocks GB1 and GB2 disposed in the second area A2 may be compensated. Accordingly, in the display apparatus 700 according to still another exemplary embodiment of the present disclosure, the RC delay for the gate signal changed due to the heterogeneous structure is compensated to be equal to that in an area without a heterogeneous structure to reduce the luminance irregularity and improve the display quality.

Therefore, in the display apparatus 700 according to still another exemplary embodiment of the present disclosure, the plurality of gate blocks GB1 and GB2 in which the gate drivers are separately disposed is distributed in the active area AA. Further, a first compensation pattern 230 for compensating the RC delay deviation is disposed in at least one gate block GB2 among the plurality of gate blocks GB1 and GB2 disposed in the second area A2 to reduce or minimize the area of the non-active area NA. Accordingly, in the display apparatus 700 according to still another exemplary embodiment of the present disclosure, the gate driver and the first compensation pattern 230 are disposed in the active area to reduce or minimize the bezel area.

Accordingly, in the display apparatus 700 according to still another exemplary embodiment of the present disclosure, the second compensation pattern 640, the third compensation pattern 650, and the fourth compensation pattern 760 are disposed to overlap a clock line CLKL disposed in at least one gate block GB1-1, among a plurality of gate blocks GB disposed in the fourth area A4. Therefore, a capacitor is formed between the clock line CLKL and the second compensation pattern 640, a capacitor is formed between the clock line CLKL and the third compensation pattern 650, and a capacitor is formed between the clock line CLKL and the fourth compensation pattern 760. Therefore, the RC delay of the clock signal transmitted through the clock line CLKL disposed in the fourth area A4 may be compensated. That is, the clock signal which is transmitted through the clock line CLKL disposed in the fourth area A4 and the clock signal which is transmitted through the clock line CLKL disposed in the third area A3 may be equally transmitted to individual gate drivers. Accordingly, in the display apparatus 700 according to still another exemplary embodiment of the present disclosure, the RC delay difference for the clock signals according to the areas due to the heterogeneous structure is compensated to be equal to reduce the luminance irregularity and improve the display quality.

A display apparatus according to exemplary embodiments of the present disclosure can also be described as follows:

A display apparatus according to an exemplary embodiment of the present disclosure includes a substrate which includes an active area having a heterogeneous side and a non-active area which is adjacent to (e.g., encloses) the active area, including a notch area defined by a shape of the heterogeneous side of the active area, a gate driver including a plurality of gate blocks disposed to be distributed in the active area and configured to output a gate signal, a plurality of gate lines connected to the plurality of gate blocks to transmit the gate signal and a first compensation pattern disposed in at least one of the plurality of gate blocks and overlapping the plurality of gate lines.

The active area may include a plurality of first areas, and at least one second area which has a smaller area than the plurality of first areas and is disposed so as to correspond to the notch area, wherein the first compensation pattern is disposed in the at least one second area.

The number of the plurality of gate blocks disposed in the at least one second area may be smaller than the number of the plurality of gate blocks disposed in the plurality of first areas.

The at least one second area may be disposed to be adjacent to at least the notch area.

The display apparatus may further include a plurality of power lines disposed to intersect the plurality of gate lines, wherein the first compensation pattern extends from the plurality of power lines while being integrated with at least one of the plurality of power lines.

A width of the plurality of power lines and the first compensation pattern in the at least one second area may be larger than a width of the plurality of power lines in the plurality of first areas.

A width of the first compensation pattern may be constant.

A width of the first compensation pattern may vary according to a position.

A width of a part of the plurality of gate lines which overlaps the first compensation pattern may be larger than a width of a part of the plurality of gate lines which does not overlap the first compensation pattern.

The display apparatus may include an active layer on the substrate, a gate insulating layer on the active layer, a gate electrode which overlaps the active layer on the gate insulating layer, a first interlayer insulating layer on the gate electrode, a second interlayer insulating layer on the first interlayer insulating layer, a source electrode and a drain electrode which are disposed on the second interlayer insulating layer and are electrically connected to the active layer, a first planarization layer on the source electrode and the drain electrode, a connection electrode disposed on the first planarization layer and electrically connected to one of the source electrode and the drain electrode, a second planarization layer on the connection electrode and a light emitting diode disposed on the second planarization layer, wherein the plurality of gate lines is disposed on the same layer as the gate electrode and the first compensation pattern is disposed on the same layer as the source electrode and the drain electrode.

The display apparatus may further include a first active layer on the substrate, a first gate insulating layer on the first active layer, a first gate electrode which overlaps the first active layer on the first gate insulating layer, a first interlayer insulating layer on the first gate electrode, a second active layer on the first interlayer insulating layer, a second gate insulating layer on the second active layer, a second gate electrode which overlaps the second active layer on the second gate insulating layer, a second interlayer insulating layer on the second gate electrode, a first source electrode and a first drain electrode which are disposed on the second interlayer insulating layer and are electrically connected to the first active layer, a second source electrode and a second drain electrode which are disposed on the second interlayer insulating layer and are electrically connected to the second active layer, a first planarization layer on the first source electrode, the first drain electrode, the second source electrode, and the second drain electrode, a connection electrode disposed on the first planarization layer and electrically connected to one of the first source electrode and the first drain electrode, a second planarization layer on the connection electrode and a light emitting diode disposed on the second planarization layer, wherein the plurality of gate lines is disposed on the same layer as the second gate electrode and the first compensation pattern is disposed on the same layer as the first source electrode, the first drain electrode, the second source electrode, and the second drain electrode.

The active area may include a third area having a first width in a column direction and a fourth area having a second width smaller than the first width in the column direction, and the display apparatus may further comprise a second compensation pattern disposed in the fourth area.

The display apparatus may further include a clock line connected to the plurality of gate blocks and intersecting the plurality of gate lines, wherein the second compensation pattern may overlap the clock line.

The display apparatus may further include a third compensation pattern which overlaps the clock line.

A width of the second compensation pattern may be constant and a length of the clock line may be different according to a position.

The clock line may have a zigzag pattern.

The display apparatus may further include an active layer on the substrate, a gate insulating layer on the active layer, a gate electrode which overlaps the active layer on the gate insulating layer, a first interlayer insulating layer on the gate electrode, a second interlayer insulating layer on the first interlayer insulating layer, a source electrode and a drain electrode which are disposed on the second interlayer insulating layer and are electrically connected to the active layer, a first planarization layer on the source electrode and the drain electrode, a connection electrode disposed on the first planarization layer and electrically connected to one of the source electrode and the drain electrode, a second planarization layer on the connection electrode and a light emitting diode disposed on the second planarization layer, wherein the second compensation pattern is disposed between the first interlayer insulating layer and the second interlayer insulating layer and the third compensation pattern is disposed on the same layer as the connection electrode.

The display apparatus may further include a first active layer on the substrate, a first gate insulating layer on the first active layer, a first gate electrode which overlaps the first active layer on the first gate insulating layer, a first interlayer insulating layer on the first gate electrode, a second active layer on the first interlayer insulating layer, a second gate insulating layer on the second active layer, a second gate electrode which overlaps the second active layer on the second gate insulating layer, a second interlayer insulating layer on the second gate electrode, a first source electrode and a first drain electrode which are disposed on the second interlayer insulating layer and are electrically connected to the first active layer, a second source electrode and a second drain electrode which are disposed on the second interlayer insulating layer and are electrically connected to the second active layer, a first planarization layer on the first source electrode, the first drain electrode, the second source electrode, and the second drain electrode, a connection electrode disposed on the first planarization layer and electrically connected to one of the first source electrode and the first drain electrode, a second planarization layer on the connection electrode and a light emitting diode disposed on the second planarization layer, wherein the second compensation pattern is disposed between the first interlayer insulating layer and the second interlayer insulating layer and the third compensation pattern is disposed on the same layer as the connection electrode.

The display apparatus may further include a fourth compensation pattern which overlaps the second compensation pattern and is disposed between the first interlayer insulating layer and the second compensation pattern.

The second compensation pattern may be electrically connected to one of a plurality of power lines.

The various embodiments described above can be combined to provide further embodiments.

## Claims

1. A display apparatus (100, 200, 300, 400, 500, 600, 700), comprising:
a substrate (110, 410) which includes an active area (AA) and a non-active area (NA) adjacent to the active area (AA), the active area (AA) including a heterogeneous side (HTRS);
a notch area (NTA) defined by a shape of the heterogeneous side (HTRS) of the active area (AA);
a gate driver including a plurality of gate blocks (GB) disposed to be distributed in the active area (AA) and configured to output a gate signal;
a plurality of gate lines (GL) electrically connected to the plurality of gate blocks (GB) and configured to transmit the gate signal; and
a first compensation pattern (130, 230, 330, 430) disposed in at least one of the plurality of gate blocks (GB) and overlapping the plurality of gate lines (GL).

2. The display apparatus (100, 200, 300, 400, 500, 600, 700) according to claim 1, wherein the active area (AA) includes:
a plurality of first areas (A1); and
at least one second area (A2) which has a smaller area than the plurality of first areas (A1) and is disposed so as to correspond to the notch area (NTA),
wherein the first compensation pattern (130, 230, 330, 430) is disposed in the at least one second area (A2).

3. The display apparatus (100, 200, 300, 400, 500, 600, 700) according to claim 2, wherein the number of the plurality of gate blocks (GB) disposed in the at least one second area (A2) is smaller than the number of the plurality of gate blocks (GB) disposed in the plurality of first areas (A1).

4. The display apparatus (100, 200, 300, 400, 500, 600, 700) according to claim 2 or 3, wherein the at least one second area (A2) is disposed to be adjacent to at least the notch area (NTA).

5. The display apparatus (100, 200, 300, 400, 500, 600, 700) according to any of claims 2 to 4, further comprising:
a plurality of power lines (VDDL, VSSL) disposed to intersect the plurality of gate lines (GL),
wherein the first compensation pattern (130, 230, 330, 430) extends from the plurality of power lines (VDDL, VSSL) while being integrated with at least one of the plurality of power lines (VDDL, VSSL).

6. The display apparatus (100, 200, 300, 400, 500, 600, 700) according to claim 5, wherein a width of the plurality of power lines (VDDL, VSSL) and the first compensation pattern (130, 230, 330, 430) in the at least one second area (A2) is larger than a width of the plurality of power lines (VDDL, VSSL) in the plurality of first areas (A1).

7. The display apparatus (100, 200, 300, 400, 500, 600, 700) according to claim 5 or 6, wherein a width of the first compensation pattern (130, 230) is constant, or wherein a width of the first compensation pattern (330) varies according to a position.

8. The display apparatus (100, 200, 300, 400, 500, 600, 700) according to any of claims 5 to 7, wherein a width of a part of the plurality of gate lines (GL) which overlaps the first compensation pattern (130, 230, 330, 430) is larger than a width of a part of the plurality of gate lines (GL) which does not overlap the first compensation pattern (130, 230, 330, 430).

9. The display apparatus (100) according to any of claims 5 to 8, further comprising:
an active layer (ACT1) on the substrate (110);
a gate insulating layer (112) on the active layer (ACT1);
a gate electrode (GE1) which overlaps the active layer (ACT1) on the gate insulating layer (112);
a first interlayer insulating layer (113) on the gate electrode (GE1);
a second interlayer insulating layer (114) on the first interlayer insulating layer (113);
a source electrode (SE1) and a drain electrode (DE1) which are disposed on the second interlayer insulating layer (114) and are electrically connected to the active layer (ACT1);
a first planarization layer (115) on the source electrode (SE1) and the drain electrode (DE1);
a connection electrode (CE) disposed on the first planarization layer (115) and electrically connected to one of the source electrode (SE1) and the drain electrode (DE1);
a second planarization layer (116) on the connection electrode (CE); and
a light emitting diode (120) on the second planarization layer (116),
wherein the plurality of gate lines (GL) is on the same layer as the gate electrode (GE1) and the first compensation pattern (130) is on the same layer as the source electrode (SE1) and the drain electrode (DE1).

10. The display apparatus (400) according to any of claims 5 to 8, further comprising:
a first active layer (ACT1) on the substrate (410);
a first gate insulating layer (412) on the first active layer (ACT1);
a first gate electrode (GE1) which overlaps the first active layer (ACT1) on the first gate insulating layer (412);
a first interlayer insulating layer (413) on the first gate electrode (GE1);
a second active layer (ACT2) on the first interlayer insulating layer (413);
a second gate insulating layer (415) on the second active layer (ACT2);
a second gate electrode (GE2) which overlaps the second active layer (ACT2) on the second gate insulating layer (415);
a second interlayer insulating layer (416) on the second gate electrode (GE2);
a first source electrode (SE1) and a first drain electrode (DE1) which are on the second interlayer insulating layer (416) and are electrically connected to the first active layer (ACT1);
a second source electrode (SE2) and a second drain electrode (DE2) which are disposed on the second interlayer insulating layer (416) and are electrically connected to the second active layer (ACT2);
a first planarization layer (417) on the first source electrode (SE1), the first drain electrode (DE1), the second source electrode (SE2), and the second drain electrode (DE2);
a connection electrode (CE) on the first planarization layer (417) and electrically connected to one of the first source electrode (SE1) and the first drain electrode (DE1);
a second planarization layer (418) on the connection electrode (CE); and
a light emitting diode (420) on the second planarization layer (418),
wherein the plurality of gate lines (GL) is on the same layer as the second gate electrode (GE2) and the first compensation pattern (430) is on the same layer as the first source electrode (SE1), the first drain electrode (DE1), the second source electrode (SE2), and the second drain electrode (DE2).

11. The display apparatus (500, 600, 700) according to any of claims 1 to 8, wherein the active area (AA) includes:
a third area (A3) having a first width in a column direction; and
a fourth area (A4) having a second width smaller than the first width in the column direction, and
the display apparatus (500, 600, 700) further comprises a second compensation pattern (540, 640) disposed in the fourth area (A4),
wherein, preferably, the second compensation pattern (540, 640) is electrically connected to one of a plurality of power lines (VDDL, VSSL).

12. The display apparatus (500, 600, 700) according to claim 11, further comprising:
a clock line (CLKL) electrically connected to the plurality of gate blocks (GB) and intersecting the plurality of gate lines (GL),
wherein the second compensation pattern (540, 640) overlaps the clock line (CLKL),
wherein, preferably, a width of the second compensation pattern (540, 640) is constant and a length of the clock line (CLKL) is different according to a position,
wherein, further preferably, the clock line (CLKL) has a zigzag pattern.

13. The display apparatus (500, 600, 700) according to claim 12, further comprising:
a third compensation pattern (550, 650) which overlaps the clock line (CLKL).

14. The display apparatus (500) according to claim 13, further comprising:
an active layer (ACT1) on the substrate (410);
a gate insulating layer (112) on the active layer (ACT1);
a gate electrode (GE1) which overlaps the active layer (ACT1) on the gate insulating layer (112);
a first interlayer insulating layer (113) on the gate electrode (GE1);
a second interlayer insulating layer (114) on the first interlayer insulating layer (113);
a source electrode (SE1) and a drain electrode (DE1) which are on the second interlayer insulating layer (113) and are electrically connected to the active layer (ACT1);
a first planarization layer (115) on the source electrode and the drain electrode;
a connection electrode (CE) on the first planarization layer (115) and electrically connected to one of the source electrode (SE1) and the drain electrode (DE1);
a second planarization layer (116) on the connection electrode (CE); and
a light emitting diode (120) on the second planarization layer (116),
wherein the second compensation pattern (540) is disposed between the first interlayer insulating layer (113) and the second interlayer insulating layer (114) and the third compensation pattern (550) is on the same layer as the connection electrode (CE).

15. The display apparatus (600, 700) according to claim 13, further comprising:
a first active layer (ACT1) on the substrate (410);
a first gate insulating layer (412) on the first active layer (ACT1);
a first gate electrode (GE1) which overlaps the first active layer (ACT1) on the first gate insulating layer (412);
a first interlayer insulating layer (413) on the first gate electrode (GE1);
a second active layer (ACT2) on the first interlayer insulating layer (413);
a second gate insulating layer (415) on the second active layer (ACT2);
a second gate electrode (GE2) which overlaps the second active layer (ACT2) on the second gate insulating layer (415);
a second interlayer insulating layer (416) on the second gate electrode (GE2);
a first source electrode (SE1) and a first drain electrode (DE1) which are on the second interlayer insulating layer (416) and are electrically connected to the first active layer (ACT1);
a second source electrode (SE2) and a second drain electrode (DE2) which are on the second interlayer insulating layer (416) and are electrically connected to the second active layer (ACT2);
a first planarization layer (417) on the first source electrode (SE1), the first drain electrode (DE1), the second source electrode (SE2), and the second drain electrode (DE2);
a connection electrode (CE) on the first planarization layer (417) and electrically connected to one of the first source electrode (SE1) and the first drain electrode (DE1);
a second planarization layer (418) on the connection electrode (CE); and
a light emitting diode (420) on the second planarization layer (418),
wherein the second compensation pattern (640) is disposed between the first interlayer insulating layer (413) and the second interlayer insulating layer (416) and the third compensation pattern (650) is on the same layer as the connection electrode (CE),
wherein the display apparatus (700) preferably further comprises:
a fourth compensation pattern (760) which overlaps the second compensation pattern (640) and is disposed between the first interlayer insulating layer (413) and the second compensation pattern (640).
